# EUROPEAN PATENT SPECIFICATION

(11) **EP 2 831 934 B1**
(45) Date of publication and mention of the grant of the patent: **11.08.2021**
(21) Application number: 12812359.3
(22) Date of filing: 12.11.2012
(51) Int. Cl.: H01L 51/44, H01L 51/42

(54) **AN ORGANIC SOLAR CELL AND METHODS THEREOF**
ORGANISCHE SOLARZELLE UND METHODEN
CELLULE SOLAIRE ORGANIQUE ET METHODES

(30) Priority: 26.03.2012 IN 1128CH2012
(43) Date of publication of application: 04.02.2015
(73) Proprietor: Jawaharlal Nehru Centre For Advanced Scientific Research, Bangalore, Karnataka 560 064 (IN)
(72) Inventor: NARAYAN, Kavassery Sureswaran, Bangalore Karnataka 560064 (IN); DAS, Anshuman Jyothi, Bangalore Karnataka 560064 (IN)
(74) Representative: Høiberg P/S
(86) International application number: PCT/IB2012/056338
(87) International publication number: WO 2013/144687

(56) References cited:
- WO-A1-03/079457
- WO-A1-2011/127131
- DE-A1-102008 045 948
- KOEPPE ET AL: "Advanced photon-harvesting concepts for low-energy gap organic solar cells", SOLAR ENERGY MATERIALS AND SOLAR CELLS, ELSEVIER SCIENCE PUBLISHERS, AMSTERDAM, NL, vol. 91, no. 11, 26 April 2007 (2007-04-26), pages 986-995, XP022047682, ISSN: 0927-0248, DOI: 10.1016/J.SOLMAT.2007.01.008
- CHIKAMATSU MASAYUKI ET AL: "Light up-conversion from near-infrared to blue using a photoresponsive organic light-emitting device", APPLIED PHYSICS LETTERS, AIP, AMERICAN INSTITUTE OF PHYSICS, MELVILLE, NY, US, vol. 81, no. 4, 22 July 2002 (2002-07-22), pages 769-771, XP012033086, ISSN: 0003-6951, DOI: 10.1063/1.1495881
- None

## Description

### Field of the Invention:

The present invention relates to photo voltaic cells having enhanced performance and a process for preparing such photo voltaic cells.

### Background of the Invention:

A photovoltaic cell (also called a solar cell) is an electrical device that converts the energy of light directly into electricity by the photovoltaic effect. The operation of a thin film photovoltaic(PV) cell requires 3 basic attributes:
(1) absorption of light and generation of electron-hole pairs or charge carriers;
(2) separation of various types of charge carriers; and
(3) separate extraction of those carriers to an external circuit.

There are a wide variety of photo voltaic cells that are available in the market and that are disclosed in literature. It has been widely accepted that efficiency of a photo voltaic cell depends (in addition to other aspects) on area of pixel. It has also been widely accepted that one of the ways to increase efficiency of a photo voltaic cell is to have a collection of interconnected small area pixels. Particularly, in respect of a normal type of organic photovoltaic cell, it is advisable to coat cathode as small patterns separated by gaps and in respect of inverted photovoltaic cells, it is advisable to coat the anode as small patterns separated by gaps as opposed to a continuous layer. One of the most common methods of fabricating such small patterns of cathode (for a normal type photovoltaic cell or alternatively small patterns of anode for an inverse type photovoltaic cell) includes designing a mask(s), placing the mask in abutting relation with an active material, providing a first coating of the cathode (or alternatively the anode) to form a pattern, removing the mask, providing a second coating of the cathode (or alternatively the anode) for shorting the patterns thus formed, and providing a final coating of the cathode (or alternatively the anode). Thus, it can be noticed that at least three coating cycles are needed to produce a photovoltaic cell having patterned cathode (or alternatively patterned anode). This is a cumbersome and an energy intensive procedure. Thus, a need has been felt to provide an alternative structure of photovoltaic cell that overcomes the disadvantage described above.

It has been further observed that when such a patterned cathode (or alternatively patterned anode) is created, dead spaces are created which tend to reduce the efficiency of the photovoltaic cells. Thus, there is a need felt to improve the efficiency of the photovoltaic cell that incorporates such dead spaces.

In addition to the above, if we consider an organic solar cell (OSC), it has been found that OSC's without encapsulation are prone to oxidation at the interface between the organic polymeric layer and the electrical contacting layer. The oxidation tends to limit the lifetime of the OSCs to a few hours. Improvements have been proposed to address the aforesaid disadvantage and have been subject of many reports. By way of example, inverting the geometry of the photovoltaic cell, providing interfacial layers between the polymer and cathode, providing external encapsulation, etc. have been reported as reducing the extent of oxidation and thereby improving the life time of the device. However, most of such improvements have come with a cost penalty.

Photovoltaic cells having an inverted geometry and solving the aforesaid problem have an additional molybdenum oxide (MoO₃) layer. Providing a coating of MoO₃ is more power consuming, due to operation of a vacuum evaporation unit. Further cells having an inverted geometry and solving the aforesaid problem use an expensive high work function metals like platinum or gold. Coating a thin film (of the order of 30 nm) requires sophisticated setup and because of which, there is substantial cost penalty. Thus, in respect of an OSC, there is a need to provide an alternative solution that leads to reducing the extent of oxidation and thereby improving the lifetime of the device. Document WO 2011/127131 A1 is directed to photovoltaic cells containing a novel electrode that can exhibit both improved light transmittance and improved electrical conductivity compared to a conventional electrode. "Advanced photon-harvesting concepts for low-energy gap organic solar cells", SOLAR ENERGY MATERIALS AND SOLAR CELLS 91 (2007) pages 986-995. (XP022047682, DOI: 10.1016/J.SOLMAT.2007.01.008) describes mechanisms to improve absorption of low-energy gap organic solar cells by harvesting antenna systems that spectrally concentrate and guide the light towards the active layer of the solar cell by photoluminescence or resonant energy transfer.

### Summary of the Invention:

Accordingly, the present invention provides a photo voltaic cell, comprising: an anode located at one extremity; a cathode located at another extremity; a pre-patterned insulating polymeric layer placed in abutting relationship with the cathode, the said pre-patterned insulating polymeric layer creating plurality of interconnected regions in the said cathode; and an active layer disposed between the anode and the pre-patterned insulating polymeric layer, the said active layer generating charge carrier upon excitation by light. The cathode comprises a plurality of interconnected cathode structures on a side abutting the pre-patterned insulating polymeric layer and an interconnecting region on an opposing side thereof, the interconnecting region further interconnecting the plurality of interconnected cathode structures.

In accordance with another aspect, the present invention provides a photo voltaic cell, comprising: an anode located at one extremity; a cathode located at another extremity; an insulating polymeric layer having dye incorporated therein being disposed between the anode and the cathode, said dye absorbing light energy of a first wavelength range and emitting light energy at a second wavelength range; and an active layer disposed between the anode and the insulating polymeric layer, the said active layer generating charge carrier upon excitation by light.

In accordance with yet another aspect, the present invention provides a photo voltaic cell, comprising: an anode located at one extremity; a cathode located at another extremity; a pre-patterned insulating polymeric layer placed in abutting relationship with the anode, the said pre-patterned insulating polymeric layer creating plurality of interconnected regions in the said anode; and an active layer disposed between the cathode and the pre-patterned insulating polymeric layer, the said active layer generating charge carrier upon excitation by light. The anode comprises a plurality of interconnected anode structures on a side abutting the pre-patterned insulating polymeric layer and an interconnecting region on an opposing side thereof, the interconnecting region further interconnecting the plurality of interconnected anode structures.

In accordance with still another aspect, the present invention provides a photo voltaic cell, comprising: an anode located at one extremity; a cathode located at another extremity; an insulating polymeric layer having dye incorporated therein being disposed between the anode and the cathode, said dye absorbing light energy of a first wavelength range and emitting light energy at a second wavelength range; and an active layer disposed between the cathode and the insulating polymeric layer, the said active layer generating charge carrier upon excitation by light.

In accordance with another aspect, the present invention provides a method of forming a photo voltaic cell, comprising:
(a) providing an anode structure comprising an anode and an active layer disposed thereupon, the said active layer generating charge carrier upon excitation by light;
(b) forming a cathode structure by locating on a top surface of a semi-solid (or molten) cathode a pre-patterned insulating polymeric layer, wherein location of the pre-patterned insulating polymeric layer on the top surface of the semi-solid cathode creates the cathode comprising plurality of interconnected cathode structures on a side abutting the pre-patterned insulating polymeric layer and an interconnecting region on an opposing side thereof, the interconnecting region further interconnecting the plurality of interconnected cathode structures; and
(c) joining the cathode and the anode structures such that the active layer is disposed between the anode and the pre-patterned insulating polymeric layer to obtain the photo voltaic cell.

In accordance with yet another aspect, the present invention provides a method of forming a photo voltaic cell, comprising:
(a) providing an anode structure comprising an anode and an active layer disposed thereupon, the said active layer generating charge carrier upon excitation by light;
(b) forming a cathode structure by providing on top of a semi-solid (or molten) cathode an insulating polymeric layer that incorporates a dye, the said dye absorbing light energy of a first wavelength and emits light energy at a second wavelength; and
(c) joining the cathode and the anode structures such that the active layer is disposed between the anode and the insulating polymeric layer incorporating the dye to obtain the photo voltaic cell.

In accordance with a further aspect, the present invention provides a method of forming a photo voltaic cell, comprising:
(a) providing a cathode structure comprising cathode and an active layer disposed thereupon, the said active layer generating charge carrier upon excitation by light;
(b) forming an anode structure by locating on a top surface of a semi-solid (or molten) anode a pre-patterned insulating polymeric layer, wherein location of the pre-patterned insulating polymeric layer on the top surface of the semi-solid anode creates the cathode comprising plurality of interconnected cathode structures on a side abutting the pre-patterned insulating polymeric layer and an interconnecting region on an opposing side thereof, the interconnecting region further interconnecting the plurality of interconnected cathode structures; and
(c) joining the cathode and the anode structures such that the active layer is disposed between the cathode and the patterned insulating polymeric layer to obtain the photo voltaic cell.

In accordance with still another aspect, the present invention provides a method of forming a photo voltaic cell, comprising:
(a) providing a cathode structure comprising a cathode and an active layer disposed thereupon, the said active layer generating charge carrier upon excitation by light;
(b) forming an anode structure by providing on top of a semi-solid (or molten) anode an insulating polymeric layer that incorporates a dye, the said dye absorbing light energy of a first wavelength and emits light energy at a second wavelength; and
(c) joining the cathode and the anode structures such that the active layer is disposed between the cathode and the insulating polymeric layer incorporating the dye to obtain the photo voltaic cell.

### Brief Description of the Accompanying Drawings:

The invention itself, together with further features and attended advantages, will become apparent from consideration of the following detailed description, taken in conjunction with the accompanying drawings, wherein:
Figure 1 illustrates a photovoltaic cell of normal geometry in accordance with a first embodiment;
Figure 2 illustrates a photovoltaic cell of normal geometry in accordance with a second embodiment;
Figure 3 illustrates a photovoltaic cell of normal geometry in accordance with a third embodiment;
Figure 4 illustrates a photovoltaic cell of normal geometry in accordance with a fourth embodiment;
Figure 5 illustrates a photovoltaic cell of normal geometry in accordance with a fifth embodiment;
Figure 6 illustrates a photovoltaic cell of normal geometry in accordance with a sixth embodiment;
Figure 7 illustrates a photovoltaic cell of normal geometry in accordance with a seventh embodiment;
Figure 8 illustrates a photovoltaic cell of normal geometry in accordance with an eighth embodiment;
Figure 9 illustrates a photovoltaic cell of inverted geometry in accordance with a first embodiment;
Figure 10 illustrates a photovoltaic cell of inverted geometry in accordance with a second embodiment;
Figure 11 illustrates a photovoltaic cell of inverted geometry in accordance with a third embodiment;
Figure 12 illustrates a photovoltaic cell of inverted geometry in accordance with a fourth embodiment;
Figure 13 illustrates a photovoltaic cell of inverted geometry in accordance with a fifth embodiment;
Figure 14 illustrates a photovoltaic cell of inverted geometry in accordance with a sixth embodiment;
Figure 15 illustrates a photovoltaic cell of inverted geometry in accordance with a seventh embodiment;
Figure 16 illustrates a photovoltaic cell of inverted geometry in accordance with an eighth embodiment;
Figure 17 illustrates a process for preparing the photovoltaic cell of normal geometry in accordance with an embodiment of the present invention;
Figure 18 illustrates a process for preparing the photovoltaic cell of inverse geometry in accordance with an embodiment of the present invention;
Figure 19 illustrates a more detailed process for preparing the photovoltaic cell of normal geometry in accordance with an embodiment of the present invention;
Figure 20 illustrates a top view of the photovoltaic cell formed by locating an insulating polymeric layer having 7 small sized circular patters;
Figure 21 illustrates a photovoltaic cell of normal geometry having the dye incorporated insulating polymeric layer in accordance with an embodiment and its mechanism of operation;
Figure 22 illustrates a photovoltaic cell of inverse geometry having the dye incorporated insulating polymeric layer in accordance with an embodiment and its mechanism of operation;
Figure 23 represents the device characteristics of ITO/PEDOT:PSS/PCPDTBT:PCBM/ Alloy based photovoltaic cell having insulating polymeric layer;
Figure 24 represents the device characteristics of ITO/PEDOT:PSS/PBDTTT-C-T: PCBM/Alloy based photovoltaic cell having insulating polymeric layer;
Figure 25 represents the comparison of the life span of three ITO/PEDOT:PSS/ PCPDTBT:PCBM/Alloy based photovoltaic cells having insulating polymeric layer with that of an Al-OSCs having external encapsulation and an Al-OSCs without external encapsulation;
Figure 26 is the exploded view of the figure 25 for the first 24 hours;
Figure 27 illustrates a graph between efficiency of the device (η) with time and the open circuit voltage (V_{oc}) with time;
Figure 28 (a) illustrates the O1s peaks obtained for the photovoltaic cell;
Figure 28 (b) illustrates the Sn3d5/2 peaks obtained for the photovoltaic cell;
Figure 28 (c) illustrates the In3d3/2 peaks obtained for the photovoltaic cell;
Figure 28 (d) illustrates the In3d5/2 peaks obtained for the photovoltaic cell;
Figure 29 illustrates a picture of the film (which is of purple color) indicating presence of the dye;
Figure 30 provides comparison of the characteristics of an ITO/PEDOT:PSS/PCPDTBT: PCBM/Alloy based photovoltaic cell having polymeric layer and an ITO/PEDOT:PSS/ PCPDTBT:PCBM/Alloy based photovoltaic cell having dye incorporated insulating polymeric layer; and
Figure 31 illustrates the absorption characteristics of the active layer, the absorption characteristics of the dye and the emission characteristics of the dye.

It may be noted that to the extent possible, like reference numerals have been used to represent like elements in the drawings. Further, skilled artisans will appreciate that elements in the drawings are illustrated for simplicity and may not have been necessarily been drawn to scale. For example, the dimensions of some of the elements in the drawings may be exaggerated relative to other elements to help to improve understanding of aspects of the present invention. Furthermore, the one or more elements may have been represented in the drawings by conventional symbols, and the drawings may show only those specific details that are pertinent to understanding the embodiments of the present invention so as not to obscure the drawings with details that will be readily apparent to those of ordinary skill in the art having benefit of the description herein.

### Detailed Description of the Invention:

While the invention is susceptible to various modifications and alternative forms, specific embodiment thereof has been shown by way of example in the drawings and will be described in detail below. It should be understood, however that it is not intended to limit the invention to the particular forms disclosed, but on the contrary, the invention is to cover all modifications, equivalents, and alternative falling within the spirit and the scope of the invention as defined by the appended claims.

The parts of the device have been represented where appropriate by conventional symbols in the drawings, showing only those specific details that are pertinent to understanding the embodiments of the present invention so as not to obscure the disclosure with details that will be readily apparent to those of ordinary skill in the art having benefit of the description herein. Similarly, the steps of a method may be providing only those specific details that are pertinent to understanding the embodiments of the present invention and so as not to obscure the disclosure with details that will be readily apparent to those of ordinary skill in the art having benefit of the description herein.

The terms "comprises", "comprising", or any other variations thereof, are intended to cover a non-exclusive inclusion, such that a process or method that comprises a list of steps does not include only those steps but may include other steps not expressly listed or inherent to such process or method. Similarly, one or more elements or structures in a photovoltaic cell proceeded by "comprises... a" does not, without more constraints, preclude the existence of other elements or other structures or additional elements or additional structures in the photovoltaic cell.

Accordingly, the present invention provides a photo voltaic cell of a normal geometry, comprising: an anode located at one extremity; a cathode located at another extremity; a patterned insulating polymeric layer placed in abutting relationship with the cathode, the said patterned insulating polymeric layer creating plurality of interconnected regions in the said cathode; and an active layer disposed between the anode and the insulating patterned polymeric layer, the said active layer generating charge carrier upon excitation by light.

The present invention also provides a photo voltaic cell of a normal geometry, comprising: an anode located at one extremity; a cathode located at another extremity; an insulating polymeric layer having dye incorporated therein being disposed between the anode and the cathode, said dye absorbing light energy of a first wavelength range and emitting light energy at a second wavelength range; and an active layer disposed between the anode and the insulating polymeric layer, the said active layer generating charge carrier upon excitation by light.

The present invention further provides a photo voltaic cell of an inverse geometry, comprising: an anode located at one extremity; a cathode located at another extremity; a patterned insulating polymeric layer placed in abutting relationship with the anode, the said patterned insulating polymeric layer creating plurality of interconnected regions in the said anode; and an active layer disposed between the cathode and the patterned insulating polymeric layer, the said active layer generating charge carrier upon excitation by light.

The present invention furthermore provides a photo voltaic cell of an inverse geometry, comprising: an anode located at one extremity; a cathode located at another extremity; an insulating polymeric layer having dye incorporated therein being disposed between the anode and the cathode, said dye absorbing light energy of a first wavelength range and emitting light energy at a second wavelength range; and an active layer disposed between the cathode and the insulating polymeric layer, the said active layer generating charge carrier upon excitation by light.

In an embodiment of the present invention, the active layer is an organic layer.

In another embodiment of the present invention, the active layer is a heterojunction layer.

In yet another embodiment of the present invention, the heterojunction layer is an organic heterojunction layer.

In still another embodiment of the present invention, the heterojunction layer is a bulk heterojunction system.

In a further embodiment of the present invention, the bulk heterojunction system comprises donor species and acceptor species.

In a further more embodiment of the present invention, the donor species are selected from the group comprising of PBDTTT-C-T, PTB7, PCPDTBT, PCDTBT, P3HT, or the like and any combinations thereof.

In another embodiment of the present invention, the acceptor species are selected from the group comprising of PC₆₀BM, PC₇₀BM, Indene-C60 Bisadduct (ICBA), Perylene, Perylene derivatives, Naphthalene, Naphthalene derivatives, Coronene, Coronene derivatives, pyrrole, pyrrole derivatives or the like and any combinations thereof.

In yet another embodiment of the present invention, the photovoltaic cells as described above (both the normal geometry as well as the inverse geometry and with or without incorporation of the dye) further comprises a hole conducting layer disposed between the anode and the active layer.

In still another embodiment of the present invention, the hole-conducting layer is selected from a group comprising PEDOT: PSS, Molybdenum Oxide, Nickel oxide, or the like.

In a further embodiment of the present invention, the cathode comprises Indium, Tin, Bismuth, Antimony, Cadmium, Lead or the like and any combination thereof in a photovoltaic cell of the normal geometry as described above (with or without incorporation of the dye).

In a further more embodiment of the present invention, the anode comprises Indium, Tin, Bismuth, Antimony, Cadmium, Lead or the like and any combination thereof in a photovoltaic cell of the inverse geometry as described above (with or without incorporation of the dye).

In another embodiment of the present invention, the cathode is optionally in the form of a metal-polymer composite in a photovoltaic cell of the normal geometry as described above (with or without incorporation of the dye).

In yet another embodiment of the present invention, the anode is optionally in the form of a metal-polymer composite in a photovoltaic cell of the inverse geometry as described above (with or without incorporation of the dye).

In still another embodiment of the present invention, the metal-polymer composite cathode comprises particulate metals selected from the group comprising of Indium, Tin, Bismuth, Antimony, Cadmium, Lead or the like and any combination thereof dispersed in a polymer matrix selected from the group comprising of polystyrene (PS), poly methyl methacrylate (PMMA), polycarbonate (PC) or the like in a photovoltaic cell of the normal geometry as described above (with or without incorporation of the dye).

In a further embodiment of the present invention, the metal-polymer composite anode comprises particulate metals selected from the group comprising of Indium, Tin, Bismuth, Antimony, Cadmium, Lead or the like and any combination thereof dispersed in a polymer matrix selected from the group comprising of polystyrene (PS), poly methyl methacrylate (PMMA), polycarbonate (PC) or the like in a photovoltaic cell of the inverse geometry as described above (with or without incorporation of the dye).

In a further more embodiment of the present invention, the photovoltaic cell of the normal geometry as described above (with or without incorporation of the dye) further comprises a substrate disposed on top of the anode.

In another embodiment of the present invention, the photovoltaic cell of the inverse geometry as described above (with or without incorporation of the dye) further comprises a substrate disposed on top of the cathode.

In yet another embodiment of the present invention (applicable for both normal geometry as well as inverse geometry and with or without incorporation of the dye), the substrate is made of glass or a transparent plastic material.

In still another embodiment of the present invention (applicable for both normal geometry as well as inverse geometry and with or without incorporation of the dye), the transparent plastic material is selected from the group comprising of polyethylene terephthalate (PET), polystyrene (PS), poly methyl methacrylate (PMMA), polycarbonate (PC) or the like.

In a further embodiment of the present invention, the anode is selected from the group comprising of Indium Tin Oxide layer, Silver nano particle ink, gold nano particle ink, silver nanowires arranged in a grid pattern, gold nanowires arranged in a grid pattern, Gallium doped Zinc Oxide layer, highly conducting PEDOT: PSS layer, or the like and any combinations thereof in a photovoltaic cell of the normal geometry as described above (with or without incorporation of the dye).

In a furthermore embodiment of the present invention, the cathode is selected from the group comprising of Indium Tin Oxide layer, Silver nano particle ink, gold nano particle ink, silver nanowires arranged in a grid pattern, gold nanowires arranged in a grid pattern, Gallium doped Zinc Oxide layer, highly conducting PEDOT: PSS layer, or the like and any combinations thereof in a photovoltaic cell of the inverse geometry as described above (with or without incorporation of the dye).

In another embodiment of the present invention, the photovoltaic cell of the normal geometry as described above (with or without incorporation of the dye) further comprises a hole-blocking, electron conducting layer disposed between the insulating polymeric layer and the active layer.

In yet another embodiment of the present invention, the photovoltaic cell of the inverse geometry as described above (with or without incorporation of the dye) further comprises a hole-blocking, electron conducting layer disposed between the cathode and the active layer.

In still another embodiment of the present invention (applicable for both normal geometry as well as inverse geometry and with or without incorporation of the dye), the hole-blocking, electron conducting layer is selected from the group comprising of Zinc oxide, Titanium dioxide, Copper oxide, Calcium, Lithium Fluoride or the like.

In a further embodiment of the present invention, the photovoltaic cell of the normal geometry as described above (with or without incorporation of the dye) further comprises a buffer enhancement layer disposed between the insulating polymeric layer and the active layer.

In a further more embodiment of the present invention, the photovoltaic cell of the inverse geometry as described above (with or without incorporation of the dye) further comprises a buffer enhancement layer disposed between the cathode and the active layer.

In another embodiment of the present invention (applicable for both normal geometry as well as inverse geometry and with or without incorporation of the dye), the buffer enhancement layer is made of a polyelectrolytic material selected from the group comprising of Poly ethylene oxide (PEO), Polyethyleneimine (PEI), Polyethyleneimine ethoxylated (PEIE), poly allyl amine (PAA), PFN electrolyte, or the like and any combinations thereof.

In yet another embodiment of the present invention (applicable for both normal geometry as well as inverse geometry), the dye exhibits prominent absorption characteristics at first wavelength range that correspond to active material's low absorption region and exhibits prominent emission characteristics at second wavelength range that correspond to active material's high absorption region.

In still another embodiment of the present invention (applicable for both normal geometry as well as inverse geometry), the dye is a fluorescent dye selected from group comprising of Benzothiazolium 2-[[2-[2-[4-(dimethylamino)phenyl]ethenyl]-6-methyl-4H-pyran-4-ylidene]methyl]-3-ethyl perchlorate, 4-(Dicyanomethylene)-2-methyl-6-(4-dimethylaminostyryl)-4H-pyran (DCM), Rhodamine 6G or the like and any combination thereof.

In a further another embodiment of the present invention (applicable for both normal geometry as well as inverse geometry and with or without incorporation of the dye), the insulating polymeric layer is selected from a group comprising of Polycarbonate, PET, PMMA, PS, PVDF or the like.

The present invention also provides a method of forming a photo voltaic cell of the normal geometry, comprising:
(a) providing an anode structure comprising an anode and an active layer disposed thereupon, the said active layer generating charge carrier upon excitation by light;
(b) forming a cathode structure by locating on a top surface of a semi-solid (or molten) cathode a patterned insulating polymeric layer, wherein location of the patterned insulating polymeric layer on the top surface of the semi-solid cathode creates plurality of interconnected regions in the said cathode; and
(c) joining the cathode and the anode structures such that the active layer is disposed between the anode and the patterned insulating polymeric layer to obtain the photo voltaic cell.

The present invention further provides a method of forming a photo voltaic cell of the normal geometry, comprising:
(a) providing an anode structure comprising an anode and an active layer disposed thereupon, the said active layer generating charge carrier upon excitation by light;
(b) forming a cathode structure by providing on top of a semi-solid (or molten) cathode an insulating polymeric layer that incorporates a dye, the said dye absorbing light energy of a first wavelength and emits light energy at a second wavelength; and
(c) joining the cathode and the anode structures such that the active layer is disposed between the anode and the insulating polymeric layer incorporating the dye to obtain the photo voltaic cell.

The present invention further more provides a method of forming a photo voltaic cell of an inverse geometry, comprising:
(a) providing a cathode structure comprising cathode and an active layer disposed thereupon, the said active layer generating charge carrier upon excitation by light;
(b) forming an anode structure by locating on a top surface of a semi-solid (or molten) anode a patterned insulating polymeric layer, wherein location of the patterned insulating polymeric layer on the top surface of the semi-solid anode creates plurality of interconnected regions in the said anode; and
(c) joining the cathode and the anode structures such that the active layer is disposed between the cathode and the patterned insulating polymeric layer to obtain the photo voltaic cell.

The present invention additionally provides a method of forming a photo voltaic cell of an inverse geometry, comprising:
(a) providing a cathode structure comprising a cathode and an active layer disposed thereupon, the said active layer generating charge carrier upon excitation by light;
(b) forming an anode structure by providing on top of a semi-solid (or molten) anode an insulating polymeric layer that incorporates a dye, the said dye absorbing light energy of a first wavelength and emits light energy at a second wavelength; and
(c) joining the cathode and the anode structures such that the active layer is disposed between the cathode and the insulating polymeric layer incorporating the dye to obtain the photo voltaic cell.

In an embodiment of the present invention, the active layer is an organic layer.

In another embodiment of the present invention, the active layer is a heterojunction layer.

In yet another embodiment of the present invention, the heterojunction layer is an organic heterojunction layer.

In still another embodiment of the present invention, the heterojunction layer is a bulk heterojunction system.

In a further embodiment of the present invention, the bulk heterojunction system comprises donor species and acceptor species.

In a further more embodiment of the present invention, the donor species are selected from the group comprising of PBDTTT-C-T, PTB7, PCPDTBT, PCDTBT, P3HT, or the like and any combinations thereof.

In another embodiment of the present invention, the acceptor species are selected from the group comprising of PC₆₀BM, PC₇₀BM, Indene-C60 Bisadduct (ICBA), Perylene, Perylene derivatives, Naphthalene, Naphthalene derivatives, Coronene, Coronene derivatives, pyrrole, pyrrole derivatives or the like and any combinations thereof.

In yet another embodiment of the present invention, the methods as described above (for preparing all four types of photovoltaic cells i.e. both the normal geometry as well as the inverse geometry and with or without incorporation of the dye) further comprises disposing a hole conducting layer between the anode and the active layer.

In still another embodiment of the present invention, the hole-conducting layer is selected from a group comprising PEDOT: PSS, Molybdenum Oxide, Nickel oxide or the like.

In a further embodiment of the present invention, in the methods for preparing the photovoltaic cell of normal geometry, the cathode comprises Indium, Tin, Bismuth, Antimony, Cadmium, Lead, or the like and any combination thereof.

In a further more embodiment of the present invention, in the methods for preparing the photovoltaic cell of inverse geometry, the anode comprises Indium, Tin, Bismuth, Antimony, Cadmium, Lead, or the like and any combination thereof.

In another embodiment of the present invention, in the methods for preparing the photovoltaic cell of normal geometry, the cathode is optionally in the form of a metal-polymer composite.

In yet another embodiment of the present invention, in the methods for preparing the photovoltaic cell of inverse geometry, the anode is optionally in the form of a metal-polymer composite.

In still another embodiment of the present invention, in the methods for preparing the photovoltaic cell of normal geometry, the metal-polymer composite cathode comprises particulate metals selected from the group comprising of Indium, Tin, Bismuth, Antimony, Cadmium, Lead, or the like and any combination thereof dispersed in a polymer matrix selected from the group comprising of polystyrene (PS), poly methyl methacrylate (PMMA), polycarbonate (PC) or the like.

In a further embodiment of the present invention, in the methods for preparing the photovoltaic cell of inverse geometry, the metal-polymer composite anode comprises particulate metals selected from the group comprising of Indium, Tin, Bismuth, Antimony, Cadmium, Lead, or the like and any combination thereof dispersed in a polymer matrix selected from the group comprising of polystyrene (PS), poly methyl methacrylate (PMMA), polycarbonate (PC) or the like.

In a further more embodiment of the present invention, the methods for preparing the photovoltaic cell of normal geometry further comprises disposing a substrate on top of the anode.

In another embodiment of the present invention, in the methods for preparing the photovoltaic cell of inverse geometry further comprises disposing a substrate on top of the cathode.

In yet another embodiment of the present invention, the substrate is made of glass or a transparent plastic material.

In still another embodiment of the present invention, the transparent plastic material is selected from the group comprising of polyethylene terephthalate (PET), polystyrene (PS), poly methyl methacrylate (PMMA), polycarbonate (PC) or the like.

In a further embodiment of the present invention, in the methods for preparing the photovoltaic cell of normal geometry, the anode is selected from the group comprising of Indium Tin Oxide layer, Silver nano particle ink, gold nano particle ink, silver nanowires arranged in a grid pattern, gold nanowires arranged in a grid pattern, Gallium doped Zinc Oxide layer, highly conducting PEDOT: PSS layer, or the like and any combinations thereof.

In a further more embodiment of the present invention, in the methods for preparing the photovoltaic cell of inverse geometry, the cathode is selected from the group comprising of Indium Tin Oxide layer, Silver nano particle ink, gold nano particle ink, silver nanowires arranged in a grid pattern, gold nanowires arranged in a grid pattern, Gallium doped Zinc Oxide layer, highly conducting PEDOT: PSS layer, or the like and any combinations thereof.

In another embodiment of the present invention, the methods for preparing the photovoltaic cell of normal geometry further comprises disposing a hole-blocking, electron conducting layer between the insulating polymeric layer and the active layer.

In yet another embodiment of the present invention, the methods for preparing the photovoltaic cell of inverse geometry further comprises disposing a hole-blocking, electron conducting layer between the cathode and the active layer.

In a further embodiment of the present invention, the electron-conducting layer is selected from the group comprising of Zinc oxide, Titanium dioxide, Copper oxide, Calcium, Lithium Fluoride, or the like.

In a further more embodiment of the present invention, the methods for preparing the photovoltaic cell of normal geometry further comprises disposing a buffer enhancement layer between the insulating polymeric layer and the active layer.

In another embodiment of the present invention, the methods for preparing the photovoltaic cell of inverse geometry further comprises disposing a buffer enhancement layer between the cathode and the active layer.

In yet another embodiment of the present invention, the buffer enhancement layer is made of a polyelectrolytic material selected from the group comprising of Poly ethylene oxide (PEO), Polyethyleneimine (PEI), Polyethyleneimine ethoxylated (PEIE), poly allyl amine (PAA), PFN electrolyte, or the like and any combinations thereof.

In still another embodiment of the present invention, the dye is a fluorescent dye selected from group comprising of Benzothiazolium 2-[[2-[2-[4-(dimethylamino)phenyl]ethenyl]-6-methyl-4H-pyran-4-ylidene]methyl]-3-ethyl perchlorate, 4-(Dicyanomethylene)-2-methyl-6-(4-dimethylaminostyryl)-4H-pyran (DCM), Rhodamine 6G, or the like and any combination thereof.

In a further embodiment of the present invention, the insulating polymeric layer is selected from a group comprising of Polycarbonate, PET, PMMA, PS, PVDF or the like.

In a further more embodiment of the present invention, forming the cathode structure in a photovoltaic cell of the normal geometry comprises:
- placing a metal foil on a heating stage;
- inducing wetting in the metal foil;
- placing molten cathode on top of the wet foil;
- locating an insulating polymeric layer on a top surface of molten cathode to obtain the cathode structure; and
- allowing the cathode structure to cool gradually and peeling off the metal foil there-from.

In another embodiment of the present invention, forming the anode structure in a photovoltaic cell of the inverse geometry comprises:
- placing a metal foil on a heating stage;
- inducing wetting in the metal foil;
- placing molten anode on top of the wet foil;
- locating an insulating polymeric layer on a top surface of molten anode to obtain the anode structure; and
- allowing the anode structure to cool gradually and peeling off the metal foil there-from.

In yet another embodiment of the present invention, the metal foil is selected from the group comprising Aluminium, Tin and a combination thereof.

In still another embodiment, the method of the present invention further comprises forming electrical leads from the cathode and the anode.

In a further embodiment of the present invention, the dye exhibits prominent absorption characteristics at first wavelength range that correspond to active material's low absorption region and exhibits prominent emission characteristics at second wavelength range that correspond to active material's high absorption region.

The Invention is hereinafter described with reference to some of the preferred modes of implementation. To the extent possible, the constructions of the photovoltaic cells and the processes involved in the fabrication of the photovoltaic cells are (which may be considered as the preferred embodiments of the invention) are described with reference to the drawings. It should however, be understood that the scope of the claims is not intended to be restricted by the description being provided hereafter and is intended to be restricted by the claims themselves and their equivalents.

As mentioned previously, it is well known that in a photovoltaic cell of normal geometry, cathodes of small areas (≈ 1 mm²) are more efficient as compared to cathodes of larger area dimension (≈ 1 cm²). This improvement is shown to arise from the fact that the region in the vicinity of the cathode also contributes to the current. Thus, it is sufficient to coat cathodes as small patterns separated by gaps instead of providing a singular cathode for the whole photovoltaic cell. In a vise-versa manner, in case of a photovoltaic cell of inverse geometry, anodes of small areas (≈ 1 mm²) are more efficient as compared to anodes of larger area dimension (≈ 1 cm²).

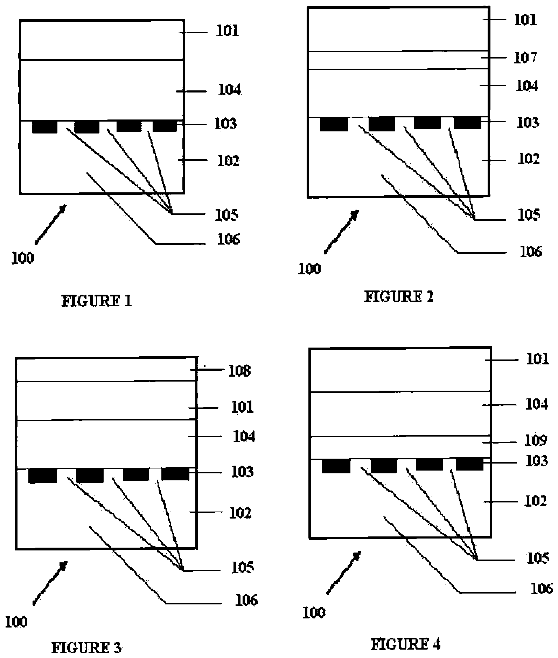

The present invention provides alternative structures for the photovoltaic cells (both for the normal geometry as well as for inverse geometry) that make the processes of their fabrication very easy and economical. To attain the aforesaid, in a respect of a photovoltaic cell of a normal geometry (100), as shown in figure 1, there is provided an anode (101) located at one extremity; a cathode (102) located at another extremity; a patterned insulating polymeric layer (103) placed in abutting relationship with the cathode, the said patterned insulating polymeric layer creating plurality of cathodes (105) interconnected by a interconnected region (106) in the said cathode (102); and an active layer (104) disposed between the anode (101) and the patterned insulating polymeric layer (103), the said active layer (104) generating charge carrier upon excitation by light.

The patterned insulating polymeric layer (103) placed in abutting relationship with the cathode (102) is of a sacrificial type meaning thereby that it is not removed and forms part of the final photovoltaic cell (i.e. the product). By placing the insulating polymeric layer (103) in abutting relation with the cathode (102) not only plurality of cathodes (105) are formed, but also, such plurality of cathodes are inherently interconnected to each other by an interconnecting region (106). In one embodiment of the present invention, the pattern formed in the insulating polymeric layer is such that cathodes (105) of small areas (≈ 1 mm²) are formed. On a side where the polymer layer abuts the cathode (102), the cathode is in the form of plurality of small area cathodes (105), while on an opposite side thereof substantially all of the pluralities of small area cathodes (105) are inherently interconnected to each other by the interconnecting region (106). The aforesaid structure of the photovoltaic cell enables the photovoltaic cell to be prepared or formed by following substantial simpler process. More particularly, it is no more required to provide plurality of coatings (as described in the process of the prior art).

In the photovoltaic cell of the normal geometry, the cathode comprises Indium, Tin, Bismuth, Antimony, Cadmium, Lead or the like and any combination thereof. In preferred aspect, the cathode is optionally in the form of a metal-polymer composite, wherein the metal-polymer composite cathode comprises particulate metals selected from the group comprising of Indium, Tin, Bismuth, Antimony, Cadmium, Lead or the like and any combination thereof dispersed in a polymer matrix selected from the group comprising of polystyrene (PS), poly methyl methacrylate (PMMA), polycarbonate (PC) or the like.

In the photovoltaic cell of the normal geometry, the anode is selected from the group comprising of Indium Tin Oxide layer, Silver nano particle ink, gold nano particle ink, silver nanowires arranged in a grid pattern, gold nanowires arranged in a grid pattern, Gallium doped Zinc Oxide layer, highly conducting PEDOT: PSS layer, or the like and any combinations thereof.

As illustrated in figure 2, the photovoltaic cell of such a normal geometry (100) can additionally include a hole-conducting layer (107) disposed between the anode (101) and the active layer (104). The hole-conducting layer is selected according to the active layer and can be any of the conventional hole conducting layers. By way of example, if the active layer is an organic insulating polymeric layer, the hole conducting layer can be PEDOT: PSS, Molybdenum Oxide, Nickel oxide, or the like.

In an alternative as illustrated in figure 3, a substrate (108) can be disposed on top of the anode. The substrate (108) can be made of any transparent conventional material such as glass or transparent plastic. If the intention if to prepare a photovoltaic cell by a roll-by-roll process, the substrate can be preferably made of transparent plastic material such as polyethylene terephthalate (PET), polystyrene (PS), poly methyl methacrylate (PMMA) and polycarbonate (PC).

In an alternative as illustrated in figure 4, a hole-blocking, electron conducting layer (109) can be disposed between the insulating polymeric layer (103) and the active layer (104). The hole-blocking, electron conducting layer (109) can be selected from the group comprising of Zinc oxide, Titanium dioxide, Copper oxide, Calcium, Lithium Fluoride or the like.

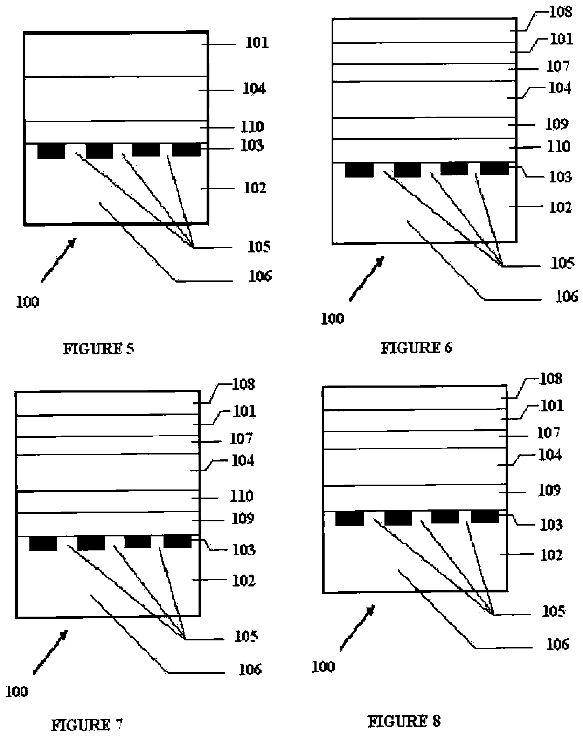

In an alternative as illustrated in figure 5, a buffer enhancement layer (110) can be disposed between the insulating polymeric layer (103) and the active layer (104). The buffer enhancement layer can be made of a polyelectrolytic material selected from the group comprising of Poly ethylene oxide (PEO), Polyethyleneimine (PEI), Polyethyleneimine ethoxylated (PEIE), poly allyl amine (PAA), PFN electrolyte, or the like and any combinations thereof.

It is possible to selectively combine the aforesaid alternatives and some of such combinations are illustrated in figures 6, 7 and 8 by way of example.

Referring to figure 6, the photovoltaic cell can comprise of a substrate (108), an anode (101), a hole conducting layer (107), an active layer (104), a hole-blocking electron conducting layer (109), a buffer enhancement layer (110), an insulating polymeric layer (103) and a cathode (102) disposed in a sequential manner. Referring to figure 7, the photovoltaic cell contains all of the layers described in figure 6.

However, in figure 7, the order of the hole-blocking electron conducting layer (109) and the buffer enhancement layer (110) are reversed. Now referring to figure 8, all the layers described in figure 6 except for the buffer enhancement layer are present.

It may be noted that a person skilled in the art can choose to combine the aforesaid alternatives in a manner different from those illustrated in figures 6 to 8 (without departing from the spirit of the invention). It can be noticed that in all of figures 2 to 8, the insulating polymeric layer (103) acts as a sacrificial element and its placement in abutting relation with the cathode (102) not only creates plurality of cathodes (105), but also, such plurality of cathodes are inherently interconnected to each other by an interconnecting region (106).

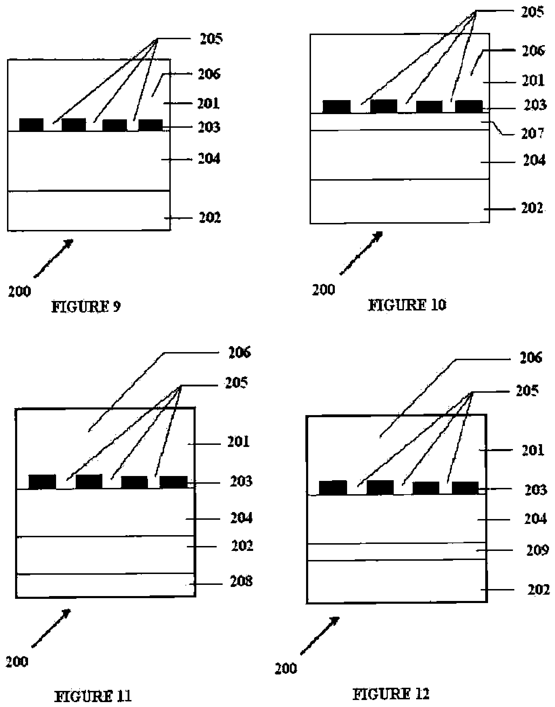

Similarly, in a respect of a photovoltaic cell of an inverse normal geometry (200), as shown in figure 9, there is provided an anode (201) located at one extremity; a cathode (202) located at another extremity; a patterned insulating polymeric layer (203) placed in abutting relationship with the anode (201), the said patterned insulating polymeric layer (203) creating plurality of anodes (205) interconnected by an interconnecting region (206) in the said anode (201); and an active layer (204) disposed between the cathode (202) and the patterned insulating polymeric layer (203), the said active layer (204) generating charge carrier upon excitation by light.

The patterned insulating polymeric layer (203) placed in abutting relationship with the anode (201) is of a sacrificial type meaning thereby that it is not removed and forms part of the final photovoltaic cell (i.e. the product). By placing the insulating polymeric layer (203) in abutting relation with the anode (201) not only plurality of anodes (205) are formed, but also, such plurality of anodes are inherently interconnected to each other by an interconnecting region (206). In one embodiment of the present invention, the pattern formed in the insulating polymeric layer is such that anodes (205) of small areas (≈ 1 mm²) are formed. On a side where the polymer layer abuts the anode (201), the anode is in the form of plurality of small area anodes (205), while on an opposite side thereof substantially all of the pluralities of small area anodes (205) are inherently interconnected to each other by the interconnecting region (206). The aforesaid structure of the photovoltaic cell enables the photovoltaic cell to be prepared or formed by following substantial simpler process. More particularly, it is no more required to provide plurality of coatings (as described in the process of the prior art).

In the photovoltaic cell of the inverse geometry, the anode comprises Indium, Tin, Bismuth, Antimony, Cadmium, Lead or the like and any combination thereof. In preferred aspect, the anode is optionally in the form of a metal-polymer composite, wherein the metal-polymer composite anode comprises particulate metals selected from the group comprising of Indium, Tin, Bismuth, Antimony, Cadmium, Lead or the like and any combination thereof dispersed in a polymer matrix selected from the group comprising of polystyrene (PS), poly methyl methacrylate (PMMA), polycarbonate (PC) or the like.

In the photovoltaic cell of the inverse geometry, the cathode is selected from the group comprising of Indium Tin Oxide layer, Silver nano particle ink, gold nano particle ink, silver nanowires arranged in a grid pattern, gold nanowires arranged in a grid pattern, Gallium doped Zinc Oxide layer, highly conducting PEDOT: PSS layer, or the like and any combinations thereof.

As illustrated in figure 10, the photovoltaic cell of such an inverse geometry (200) can additionally include a hole-conducting layer (207) disposed between the insulating polymeric layer (203) and the active layer (204). The hole-conducting layer is selected according to the active layer and can be any of the conventional hole conducting layers. By way of example, if the active layer is an organic insulating polymeric layer, the hole conducting layer can be PEDOT: PSS, Molybdenum Oxide, Nickel oxide, or the like.

In an alternative as illustrated in figure 11, a substrate (208) can be disposed on top of the cathode (202). The substrate (208) can be made of any transparent conventional material such as glass or transparent plastic. If the intention if to prepare a photovoltaic cell by a roll-by-roll process, the substrate can be preferably made of transparent plastic material such as polyethylene terephthalate (PET), polystyrene (PS), poly methyl methacrylate (PMMA) and polycarbonate (PC).

In an alternative as illustrated in figure 12, a hole-blocking, electron conducting layer (209) can be disposed between the cathode (202) and the active layer (204). The hole-blocking, electron conducting layer (209) can be selected from the group comprising of Zinc oxide, Titanium dioxide, Copper oxide, Calcium, Lithium Fluoride or the like.

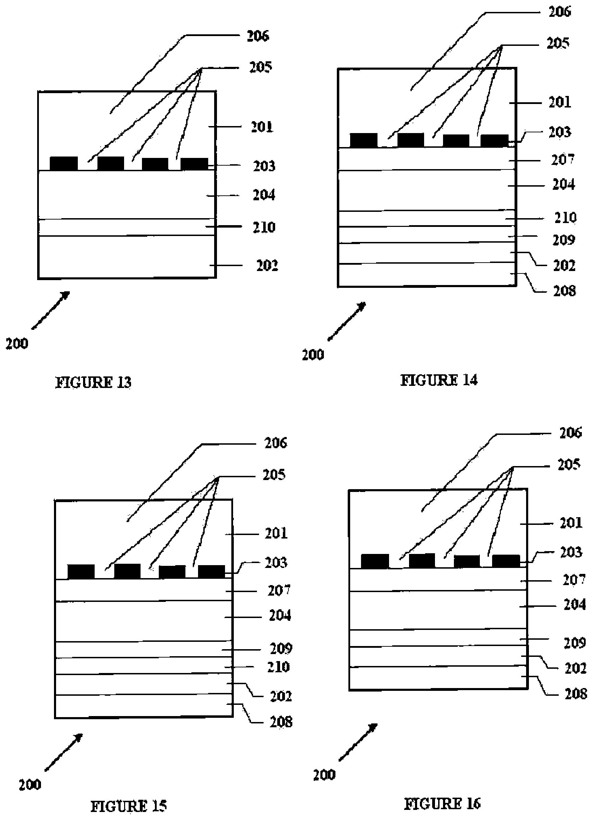

In an alternative as illustrated in figure 13, a buffer enhancement layer (210) can be disposed between the cathode (202) and the active layer (204). The buffer enhancement layer can be made of a polyelectrolytic material selected from the group comprising of Poly ethylene oxide (PEO), Polyethyleneimine (PEI), Polyethyleneimine ethoxylated (PEIE), poly allyl amine (PAA), PFN electrolyte, or the like and any combinations thereof.

It is possible to selectively combine the aforesaid alternatives and some of such combinations are illustrated in figures 14, 15 and 16 by way of example.

Referring to figure 14, the photovoltaic cell can comprise of a substrate (208), a cathode (202), a hole-blocking electron conducting layer (209), a buffer enhancement layer (210), an active layer (204), a hole conducting layer (207), an insulating polymeric layer (203) and an anode (201) disposed in a sequential manner. Referring to figure 15, the photovoltaic cell contains all of the layers described in figure 14. However, in figure 15, the order of the hole-blocking electron conducting layer (209) and the buffer enhancement layer (210) are reversed. Now referring to figure 16, all the layers described in figure 14 except for the buffer enhancement layer are present.

It may be noted that a person skilled in the art can choose to combine the aforesaid alternatives in a manner different from those illustrated in figures 14 to 16 (without departing from the spirit of the invention). It can be noticed that in all of figures 10 to 16, the insulating polymeric layer (203) acts as a sacrificial element and its placement in abutting relation with the anode (201) not only creates plurality of anodes (205), but also, such plurality of anodes are inherently interconnected to each other by an interconnecting region (206).

The aforesaid structures can be adopted while preparing various types of photovoltaic cells (i.e. without any substantial limitation regarding the choice of the materials). In other words, the aforesaid structure can be adopted for forming non-organic photovoltaic cells (such as silicon based photovoltaic cells) as well as for forming organic photovoltaic cells (or alternatively referred to as organic solar cells (OSCs)). In an organic photovoltaic cell, conductive organic polymers or small organic molecules produce the photovoltaic effect. The aforesaid structure can be adopted for forming single junction photo voltaic cells as well as for forming multi-junction photovoltaic cells. As is a well-known state of the art, a single junction photo voltaic cell comprises a single active layer disposed between the cathode and the anode while a multi-junction photovoltaic cell comprises at least two active layers disposed between the cathode and the anode. In the specification the terms "multi-junction" and "hetero junction" have been used as alternatives for one another. Therefore, in some places, multi-junction organic solar cells have been referred to as hetero junction organic solar cell or alternatively as hetero junction photovoltaic cell. Thus, the aforesaid structure can be adopted for preparing:
(a) non-organic, single-junction photovoltaic cells;
(b) non-organic, multi-junction photovoltaic cells;
(c) organic, single-junction photovoltaic cells; or
(d) organic, multi-junction photovoltaic cells.

In preferred aspect, the aforesaid structure can be adopted for forming organic solar cells. In a more preferred aspect, the aforesaid structure can be adopted for forming hetero junction organic solar cells. In a furthermore preferred aspect, the aforesaid structure can be adopted for forming a bulk hetero junction organic solar cell. As is known, in a bulk hetero junction organic solar cell, the electron donor and acceptor are mixed together, forming a polymer blend. The donor species can be selected from the group comprising of PBDTTT-C-T, PTB7, PCPDTBT, PCDTBT, P3HT, or the like and any combinations thereof. The acceptor species can be selected from the group comprising of PC₆₀BM, PC₇₀BM, Indene-C₆₀ Bisadduct (ICBA), Perylene, Perylene derivatives, Naphthalene, Naphthalene derivatives, Coronene, Coronene derivatives, pyrrole, pyrrole derivatives or the like and any combinations thereof.

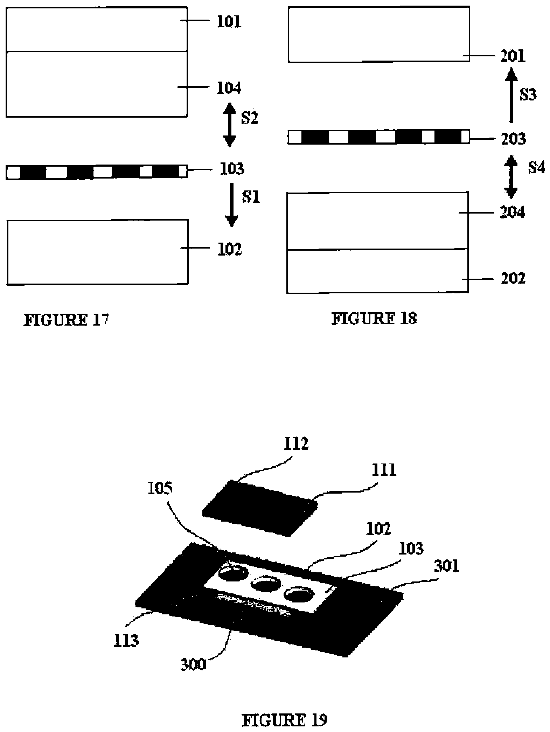

Referring to figure 17, the present invention also provides a method of forming a photo voltaic cell (100) of the normal geometry (as described illustrated in figure 1), comprising the steps of:
(a) providing an anode structure (111) comprising an anode (101) and an active layer (104) disposed thereupon, the said active layer (104) generating charge carrier upon excitation by light;
(b) forming a cathode structure (not explicitly shown in figure 17) by locating (S1) on a top surface of a semi-solid (or molten) cathode (102) a patterned insulating polymeric layer (103), wherein location of the patterned insulating polymeric layer on the top surface of the semi-solid cathode creates plurality of interconnected regions in the said cathode; and
(c) joining (S2) the cathode and the anode structures such that the active layer is disposed between the anode and the patterned insulating polymeric layer to obtain the photo voltaic cell.

It may be noted that if the intention is to form the photovoltaic cell as illustrated in figure 2, the step of providing an anode structure (111) will comprise of providing an anode structure comprising an anode (101), a hole conducting layer (107) and an active layer (104) disposed sequentially.

Similarly, if the intention is to form the photovoltaic cell as illustrated in figure 3, a substrate (108) can be disposed on top of the anode. This, can be done after the photovoltaic cell has been formed or alternatively by forming the anode structure at the initial stage on the substrate.

Likewise, if the intention is to form the photovoltaic cell as illustrated in figure 4, a hole-blocking, electron conducting layer (109) can be disposed on top of the insulating polymeric layer (103) during the step of preparing the cathode structure and thereafter the cathode and the anode structures can be joined in step (S2). Alternatively, the step of providing an anode structure (111) can comprise of providing an anode structure comprising an anode (101), an active layer (104) and the electron-conducting layer (109) disposed sequentially.

Likewise, if the intention is to form the photovoltaic cell as illustrated in figure 5, a buffer enhancement layer (110) can be disposed on top of the insulating polymeric layer (103) during the step of preparing the cathode structure and thereafter the cathode and the anode structures can be joined in step (S2). Alternatively, the step of providing an anode structure (111) can comprise of providing an anode structure comprising an anode (101), an active layer (104) and the buffer enhancement layer (110) disposed sequentially.

By adopting similar processes, it is possible to form the photovoltaic cells illustrated in figures 6, 7 and 8.

Referring to figure 18, the present invention also provides a method of forming a photo voltaic cell (200) of the inverse geometry (as described illustrated in figure 9), comprising the steps of:
(a) providing a cathode structure (212) comprising cathode (202) and an active layer (204) disposed thereupon, the said active layer (204) generating charge carrier upon excitation by light;
(b) forming an anode structure (not explicitly shown) by locating (S1) on a top surface of a semi-solid (or molten) anode (201) a patterned insulating polymeric layer (203), wherein location of the patterned insulating polymeric layer (203) on the top surface of the semi-solid anode creates plurality of interconnected regions in the said anode; and
(c) joining (S2) the cathode and the anode structures such that the active layer is disposed between the cathode and the patterned insulating polymeric layer to obtain the photo voltaic cell.

It may be noted that if the intention is to form the photovoltaic cell as illustrated in figure 10, the step of providing an cathode structure (212) can comprise of providing a cathode structure comprising a cathode (202), an active layer (204) and a hole conducting layer (207) disposed sequentially. Alternatively, the hole-conducting layer (207) can be disposed on top of the insulating polymeric layer (203) during the step of preparing the anode structure and thereafter the cathode and the anode structures can be joined in step (S2).

Similarly, if the intention is to form the photovoltaic cell as illustrated in figure 11, a substrate (208) can be disposed on top of the cathode (202). This, can be done after the photovoltaic cell has been formed or alternatively by forming the cathode structure (212) at the initial stage on the substrate.

Likewise, if the intention is to form the photovoltaic cell as illustrated in figure 12, the step of providing a cathode structure (212) can comprise of providing a cathode structure comprising cathode (202), a hole-blocking, electron conducting layer (209) and an active layer (104) disposed sequentially.

Likewise, if the intention is to form the photovoltaic cell as illustrated in figure 13, the step of providing a cathode structure (212) can comprise of providing a cathode structure comprising cathode (202), a buffer enhancement layer (210) and an active layer (104) disposed sequentially.

By adopting similar processes, it is possible to form the photovoltaic cells illustrated in figures 14, 15 and 16.

It can be clearly noticed from the above described methods of forming the photovoltaic cells, that the insulating polymeric layer (103 or alternatively 203) is not removed and is purposefully allowed to form part of the final product.

Figure 19, provides a more elaborative illustration of the process of preparing the photovoltaic cell of the normal geometry. As per the shown procedure, the process starts with the step of placing a metal foil (300) on a heating stage (301). Wetness is induced in the metal foil (either prior to or subsequent to placement of the metal foil on the heating stage). The wetness can be induced, by way of example, by rubbing a swab dipped in the molten cathode material. It may be noted that other techniques of inducing wetting in the foil can be adopted. It is also envisaged that the step of wetting the metal foil can be performed as an optional step. Thereafter, cathode (102) in molten form is placed on top of the metal foil and the insulating polymeric layer (103) is located on a top surface of molten cathode to obtain plurality of cathodes (105) interconnected by an interconnecting region (106) in the said cathode (102). By following the aforesaid procedure, the cathode structure is formed. Thereafter, the anode structure (prepared as described in the aforesaid paragraphs) is brought in contact with the cathode structure and is joined. The anode and the cathode structures can be joined by any conventional technique including by way of example, ultra sonic soldering. The metal foil is thereafter peeled and appropriate electrical terminals (112 and 113) are formed (from the cathode and the anode). The metal foil can be made of a material that does not hinder with the formation of the cathode and can be made of metals such as aluminum, tin or the like. Coming to the metals (or alloys) for use in formation of the cathode (in respect of a photovoltaic cell of normal geometry or alternatively the anode in respect of a photovoltaic cell of inverse geometry), Indium, Tin, Bismuth, Antimony, Cadmium, Lead or the like and any combination thereof can be used. In case of alloys, the same can comprise of 0 to 10 wt% of antimony, 0 to 60 wt% of bismuth, 0 to 45 wt% of lead, 0 to 60 wt% of tin, 0 to 10 wt% of cadmium and 0 to 55 wt% indium. Particularly, the alloys indicated in Table 1 herein below can be used.

**Table 1: List of Alloys for use in making Cathode (for normal geometry) or Anode (for inverse geometry)**

| Type/ Approx (°F) Temp | Antimony | Bismuth | Cadmium | Lead | Tin | Indium |
|---|---|---|---|---|---|---|
| 117 | 0% | 44.7% | 5.3% | 22.6% | 8.3% | 19.1% |
| **136** | **0 %** | **49%** | **0%** | **18%** | **12%** | **21%** |
| 140 | 0% | 47.5% | 9.5% | 25.4% | 12.6% | 5% |
| 144 | 0% | 32.5% | 0% | 0% | 16.5 % | 51 % |
| 147 | 0% | 48% | 9.6% | 25.6% | 12.8% | 4% |
| 158 | 0% | 50% | 10% | 26.7% | 13.3% | 0% |
| 158-190 | 0% | 42.5% | 8.5% | 37.7% | 11.3% | 0% |
| **203** | **0%** | **52.5%** | **0%** | **32%** | **15.5%** | **0%** |
| **212** | **0%** | **39.4%** | **0%** | **29.8%** | **30.8%** | **0%** |
| **217-440** | **9%** | **48%** | **0%** | **28.5%** | **14.5%** | **0%** |
| **255** | **0%** | **55.5%** | **0%** | **44.5%** | **0%** | **0%** |
| **281** | **0%** | **58%** | **0%** | **0%** | **42%** | **0%** |
| **281-338** | **0%** | **40%** | **0%** | **0%** | **60%** | **0%** |
| **257** | **0%** | **0%** | **0%** | **0%** | **50%** | **50%** |

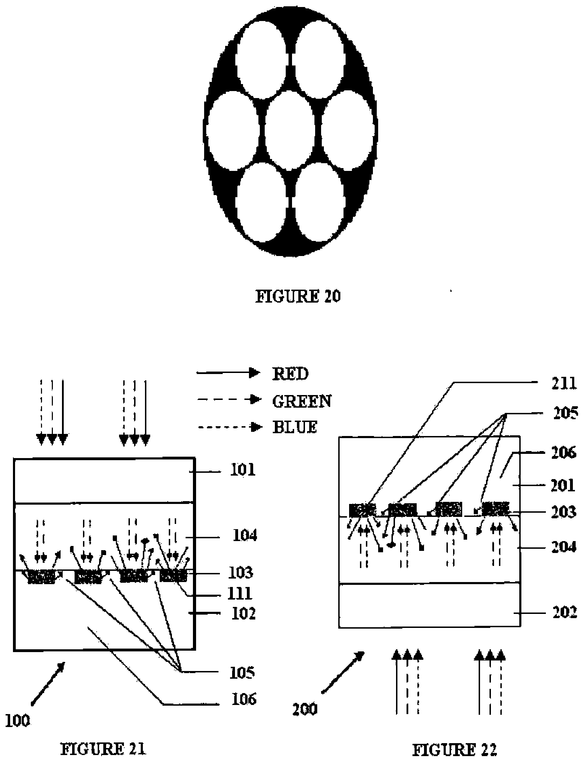

A top view of the photovoltaic cell formed by locating an insulating polymeric layer having 7 small sized circular patterns is shown in figure 20. It may be noted that the insulating polymeric layer can have patterns other than what has been specifically illustrated.

It may be noted that incorporation of the insulating polymeric layer within the photovoltaic cell serves dual purpose namely (a) creates plurality of electrodes which are interconnected by an interconnecting layer and (b) acts as an immediate encapsulating layer. The presence of the immediate encapsulating layer within the photovoltaic cell reduces the oxidation at the interface between the organic insulating polymeric layer and the electrical contacting layer and thereby increases the life span of the photovoltaic cell.

As described in the background section, it has been further observed that when such a patterned cathode (or alternatively patterned anode) is created, dead spaces are created that limit the charge collection to the regions where the electrode is present and thereby reducing the efficiency of the photovoltaic cell. Referring to figure 20, the portion shaded in black acts as dead spaces. It is also a common knowledge that the active layer (which comprises the donor species) seldom has a flat absorption spectrum. More particularly, the donor species exhibit absorption spectrum having peaks at predetermined wavelength regions and valleys in valleys in the remaining wavelength regions.

Keeping in view the above disadvantages, the present invention provides a photo voltaic cell (100) of normal geometry, as illustrated in figure 21, comprising: an anode (101) located at one extremity; a cathode (102) located at another extremity; an insulating polymeric layer (103) having dye (111) incorporated therein being disposed between the anode (101) and the cathode (102), said dye (111) absorbing light energy of a first wavelength range and emitting light energy at a second wavelength range; and an active layer (104) disposed between the anode (101) and the insulating polymeric layer (103), the said active layer (104) generating charge carrier upon excitation by light.

In accordance with still another aspect, the present invention provides a photo voltaic cell of inverse geometry, as illustrated in figure 22, comprising: an anode (201) located at one extremity; a cathode (202) located at another extremity; an insulating polymeric layer (203) having dye (211) incorporated therein being disposed between the anode (201) and the cathode (202), said dye (211) absorbing light energy of a first wavelength range and emitting light energy at a second wavelength range; and an active layer (204) disposed between the cathode (202) and the insulating polymeric layer (203), the said active layer (204) generating charge carrier upon excitation by light.

The present invention is based on the observation that the region in the vicinity of the cathode does show charge collection ability and it is possible to compensate for the loss (caused because of dead spaces in the device geometry) by generating more charges in the active region in the vicinity of the electrode. To attain an increase in the charge generation, the present invention teaches using dye(s) that exhibits prominent absorption characteristics at first wavelength range that correspond to active material's low absorption region and exhibits prominent emission characteristics at second wavelength range that correspond to active material's high absorption region. This approach also takes care of the fact that the active layer seldom has a flat absorption spectrum. Particularly, the present invention teaches incorporating the dye in the vicinity of the electrode to facilitate increased charge generation in the active region in the vicinity of the electrode. More particularly, the present invention teaches incorporating the dye in the insulating polymeric layer.

Referring once again to figures 21 and 22, photons of all colors (RGB arrows,) are incident on the device. Assuming that the active layer absorbs photons corresponding to red light, a substantial amount of photons corresponding to blue light and green light (blue arrows and green arrows) reaches the regions in the vicinity of the electrode. The insulating polymeric layer having the dye incorporated therein absorbs the photons corresponding to the blue light or green light or both and emits photons corresponding to red light.

Although, not illustrated, it is also possible that the active layer absorbs photons corresponding to blue light, in which case, a substantial amount of photons corresponding to red light and green light would reach the regions in the vicinity of the electrode. The dye incorporated in the insulating polymeric layer can be chosen to absorb photons corresponding to the red light or green light or both and emit photons corresponding to blue light. Alternatively, the active layer may absorb photons corresponding to red and blue light, in which case, a substantial amount of photons corresponding to green light would reach the regions in the vicinity of the electrode. The dye incorporated in the insulating polymeric layer can be chosen to absorb photons corresponding to the green light and emit photons corresponding to red light or and blue light or both red and blue lights. Thus, the dye can be said to exhibit prominent absorption characteristics at first wavelength range that corresponds to active material's low absorption region and exhibit prominent emission characteristics at second wavelength range that corresponds to active material's high absorption region.

The dye is preferably a fluorescent dye and can be selected from group comprising of Benzothiazolium 2-[[2-[2-[4-(dimethylamino)phenyl]ethenyl]-6-methyl-4H-pyran-4-ylidene]methyl]-3-ethyl perchlorate, 4-(Dicyanomethylene)-2-methyl-6-(4-dimethylaminostyryl)-4H-pyran (DCM), Rhodamine 6G or the like and any combination thereof. However, it may noted that any other dye which can perform the aforesaid functionality can also be used in place of the above mentioned preferred choices.

It may be noted that the following combinations of donor and dye are clearly envisaged as they tend to be very effective:
Benzothiazolium 2-[[2-[2-[4-(dimethylamino)phenyl]ethenyl]-6-methyl-4H-pyran-4-ylidene]methyl]-3-ethyl perchlorate and PCPDTBT;
DCM and PCPDTBT;
DCM and P3HT;
Rhodamine 6G and PCPDTBT; and
Rhodamine 6G and P3HT.

The working of the invention is herein after demonstrated using a few examples. It may be noted that merely for the sake of simplicity, the photovoltaic cells of normal geometry are constructed in the following examples and their functioning illustrated.

### Example 1: ITO/PEDOT:PSS/PCPDTBT:PCBM/Alloy Based Photovoltaic Cell Having Insulating Polymeric Layer

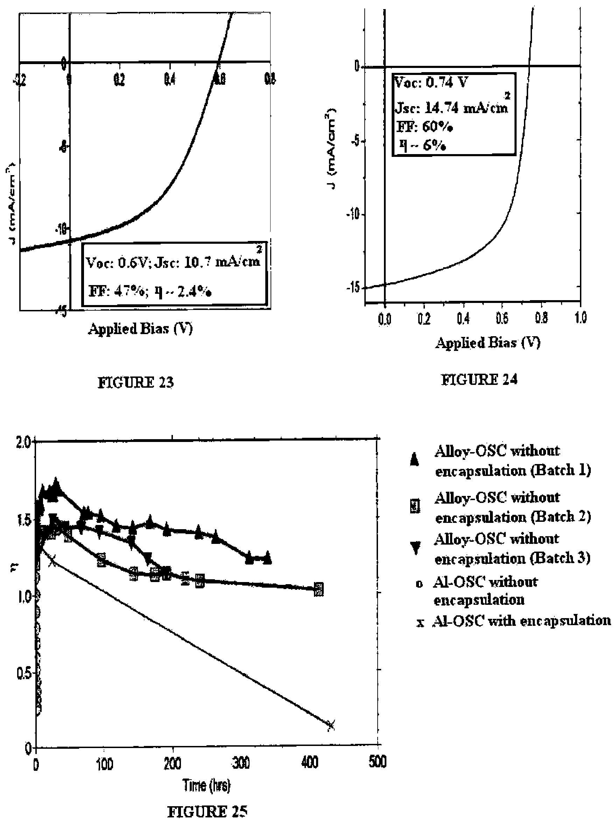

A device structure comprising of Indium tin oxide (as anode); PEDOT:PSS (as hole conducting layer), PCPDTBT:PCBM (as active layer) and an alloy of indium, tin, lead and bismuth having an insulating polymeric layer sandwiched between the alloy layer and the active layer is prepared in accordance with the process described in figure 17 and more particularly figure 19. The fabrication process involves melting the alloy from a slab and placing it on a clean glass slide (heating stage) maintained at 64°C (preferably maintained above the melting point temperature of the alloy). More particularly, a metal foil (having preferably high melting point as compared to the alloy) is placed on the heating stage and a swab dipped in the alloy is rubbed on the foil to induce wetting. The alloy drop is then cast on the foil and the surface is cleaned to remove oxides and impurities. A perforated polycarbonate (PC) or polyethylene terephthalate (PET) sheet (patterned insulating polymeric layer) is placed in the clean, molten alloy preferably at temperatures lower than the degradation of the insulating polymeric layer. The perforations contained in the sheet define the area of the cathode (sub-cells). The area of the perforations is kept as 0.02 cm². A polymer blend (active material) is coated on a structure containing ITO (as anode) and PEDOT:PSS (as the hole conducting layer) to prepare the anode structure. The active layer comprises PCPDTBT and PCBM in the ratio of 1:3.5 and the same is spin cast at about 1500 to about 2000 rpm from a 20 to 30 mg/ml solution in chlorobenzene. The aforesaid anode structure is then brought in contact with the alloy. The contact is allowed to stay for 10 minutes and then the temperature is reduced to about 50°C. Contacts are directly formed from the anode and the alloy after the foil is peeled off. The device characteristics of the photovoltaic cell are evaluated. As shown in figure 23, typical device characteristics are V_{oc}∼ 0.6 V, J_{sc}∼ 10.7 mA/cm² under 120 mW/cm² AM 1.5G illumination, η∼ 2.4%.

### Example 2: ITO/PEDOT:PSS/PBDTTT-C-T:PCBM/Alloy Based Photovoltaic Cell Having Insulating Polymeric Layer

A device structure comprising of Indium tin oxide (as anode); PEDOT:PSS (as hole conducting layer), PBDTTT-C-T:PCBM (as active layer) and an alloy of indium, tin, lead and bismuth having an insulating polymeric layer sandwiched between the alloy layer and the active layer is prepared in accordance with the process described in figure 17 and more particularly, figure 19. The fabrication process involves melting the alloy from a slab and placing it on a clean glass slide (heating stage) maintained at 64°C (preferably maintained above the melting point temperature of the alloy). More particularly, a metal foil (having preferably high melting point as compared to the alloy) is placed on the heating stage and a swab dipped in the alloy is rubbed on the foil to induce wetting. The alloy drop is then cast on the foil and the surface is cleaned to remove oxides and impurities. A perforated polycarbonate (PC) or polyethylene terephthalate (PET) sheet (patterned insulating polymeric layer) is placed in the clean, molten alloy preferably at temperatures lower than the degradation of the insulating polymeric layer. The perforations contained in the sheet define the area of the cathode (sub-cells). The area of the perforations is kept as 0.02 cm². A polymer blend (active material) is coated on a structure containing ITO (as anode) and PEDOT:PSS (as the hole conducting layer) to obtain an anode structure. The active layer comprises PBDTTT-C-T:PCBM and the same is spin cast at about 1500 to about 2000 rpm from a 20 to 30 mg/ml solution in chlorobenzene. The aforesaid anode structure is then brought in contact with the alloy. The contact is allowed to stay for 10 minutes and then the temperature is reduced to about 50°C. Contacts are directly formed from the anode and the alloy after the foil is peeled off. The device characteristics of the photovoltaic cell are evaluated. As shown in figure 24, typical device characteristics are V_{oc}∼ 0.74 V, J_{sc}∼ 14.74 mA/cm² under 120 mW/cm² AM 1.5G illumination, η∼ 6%.

### Example 3: Life Span Evaluation

Three batches of photovoltaic cells comprising of Indium tin oxide (as anode); PEDOT:PSS (as hole conducting layer), PCPDTBT:PCBM (as active layer) and an alloy of indium, tin, lead and bismuth having an insulating polymeric layer sandwiched between the alloy layer and the active layer are prepared in accordance with the process described in Example 1. One photovoltaic cell from each batch is randomly chosen. Two additional photovoltaic cells are prepared as per the teachings of the prior art i.e. without incorporating the insulating polymeric layer. Each of the said additional photovoltaic cell has Indium tin oxide (as anode); PEDOT:PSS (as hole conducting layer), PCPDTBT:PCBM (as active layer) and Al as cathode (referred to as AL-OSCs). One out of the two additional photovoltaic cells is provided with external encapsulation. The five photovoltaic cells thus obtained (3 prepared in accordance with the process described in Example 1, one prepared as per the prior art with encapsulation and one prepared as per the prior art without encapsulation) are tested for their life span. The results of the test are illustrated in Figure 25. It can be observed from Figure 25 that the device of he prior art without encapsulation degrades and the efficiency falls to under 10% of its original within 2 hr of fabrication. Even in case of the prior art device with encapsulation, the efficiency falls to under 10% in about 400 hours of fabrication. On the contrary, the photovoltaic cells prepared in accordance with the teachings of the present invention show a drop of about 18% after 400 to 500 hours of fabrication. Hence the life span of the photovoltaic cell is drastically improved both compared with the prior art device without encapsulation as well as the prior art device with encapsulation.

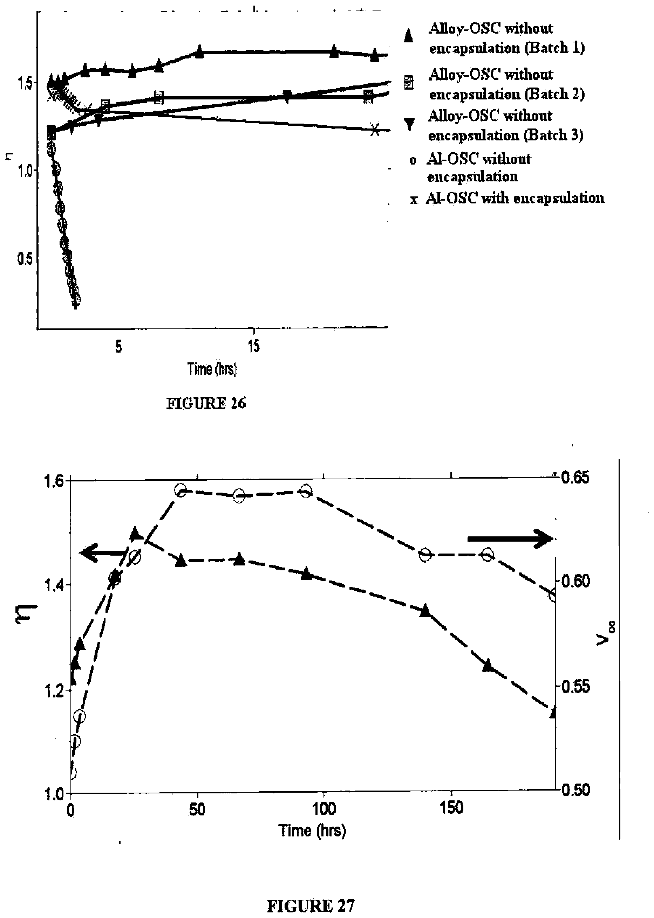

Referring to figure 26, which is exploded view of figure 25 for the first 24 hours, it an be observed the photovoltaic cells prepared in accordance with the teachings of the present invention show an increase of 15% in the efficiency after 24 hr of fabrication. Referring to figure 27, the initial increase in efficiency of the device (η) with time is due to an increase in the open circuit voltage (V_{oc}) with time.

### Example 4: XPS spectra evaluation of the cathode

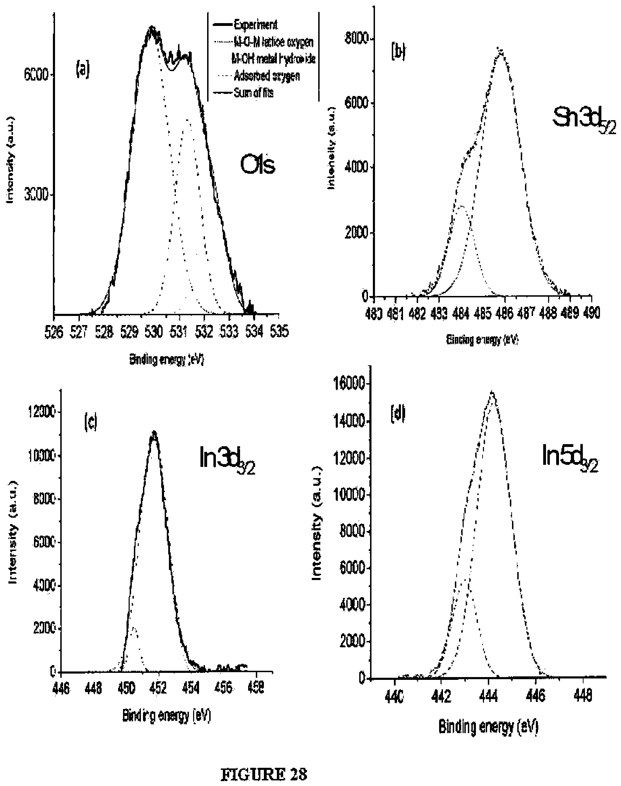

To more clearly understand the reason for the initial increase in efficiency of the device, XPS spectra of the alloy exposed to air was obtained and compared with literature. The same is illustrated in Figures 28(a) to 28(d). Figure 28 (a) shows the O1s peaks wherein the peak labeled as I may have appeared at 529.9 eV due to M-O-M lattice oxygen, peak II may have appeared at 531.3 eV due to M-OH metal hydroxide oxygen, and peak III may have appeared at 532.3 eV due to adsorbed oxygen. Figure 28 (b) correspond to the Sn3d5/2 peak obtained and the same confirm the presence of oxides of Tin. The presence of the peak at 484.6 eV indicates the native Tin and the peak at 486 eV indicates oxides of Tin such as SnO and SnO₂. Figure 28 (c) and figure 28 (d) correspond to the In3d3/2 and In3d5/2 peaks and the same indicate formation of oxides of Indium like In₂O₃. Pristine Indium peaks appear at 443.3 eV and 450 eV for 3d5/2 and 3d3/2 doublet, respectively. While the corresponding oxides occur at 444.4 eV and 451.9 eV, respectively.

Although not wishing to be bound by any one theory, it is believed that this partial oxidation is dependent on the film quality of the insulating polymeric layer and insulating polymeric films with low surface roughness do not show considerable increase in V_{oc} with time, as they are no air pockets present during the fabrication that can assist oxide formation. Films with higher surface roughness show V_{oc} changes from 0.4 V to 0.6 V after 24 hr of fabrication. Without wishing to be bound by any one theory, it is believed that this increase in V_{oc} is primarily the reason for increasing the efficiency (η) with time as shown in figure 27. Since the oxidation in the present instance is not as severe as that of the prior art and since the performance of the device deteriorates only marginally even after 400 to 500 hours of fabrication, in some cases, partial formation of the oxides may allowed, in light of the increase in Voc, increase in η, cost benefit analysis and other factors such as the end utility.

### Example 5: ITO/PEDOT:PSS/PCPDTBT:PCBM/Alloy Based Photovoltaic Cell Having Dye Incorporated Insulating Polymeric Layer

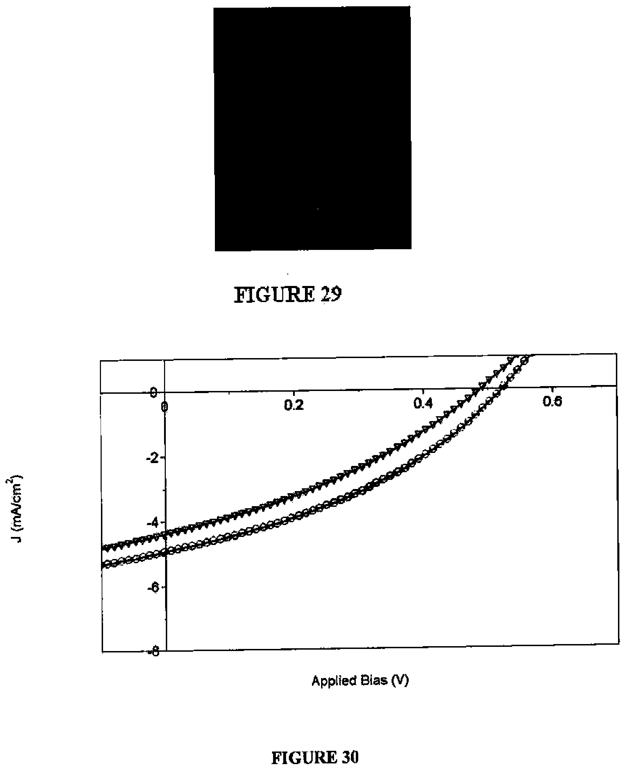

A device structure comprising of Indium tin oxide (as anode); PEDOT:PSS (as hole conducting layer), PCPDTBT:PCBM (as active layer) and an alloy of indium, tin, lead and bismuth having a dye incorporated insulating polymeric layer sandwiched between the alloy layer and the active layer is prepared in accordance with the process described in figure 17 and more particularly, figure 19. The fabrication process involves melting the alloy from a slab and placing it on a clean glass slide (heating stage) maintained at 64°C (preferably maintained above the melting point temperature of the alloy). More particularly, a metal foil (having preferably high melting point as compared to the alloy) is placed on the heating stage and a swab dipped in the alloy is rubbed on the foil to induce wetting. The alloy drop is then cast on the foil and the surface is cleaned to remove oxides and impurities. A perforated polycarbonate (PC) or polyethylene terephthalate (PET) sheet having 5 wt% of Benzothiazolium 2-[[2-[2-[4-(dimethylamino)phenyl]ethenyl]-6-methyl-4H-pyran-4-ylidene]methyl]-3-ethyl perchlorate is prepared and is placed in the clean, molten alloy preferably at temperatures lower than the degradation of the insulating polymeric layer. Referring to figure 29, the film is of purple color indicating the presence of dye. The perforations contained in the sheet define the area of the cathode (sub-cells). The area of the perforations is kept as 0.02 cm². A polymer blend (active material) is coated on a structure containing ITO (as anode) and PEDOT:PSS (as the hole conducting layer) to obtain an anode structure. The active layer comprises PCPDTBT and PCBM in the ratio of 1:3.5 and the same is spin cast at about 1500 to about 2000 rpm from a 20 to 30 mg/ml solution in chlorobenzene. The aforesaid anode structure is then brought in contact with the alloy. The contact is allowed to stay for 10 minutes and then the temperature is reduced to about 50°C. Contacts are directly formed from the anode and the alloy after the foil is peeled off. The device characteristics of the photovoltaic cell are evaluated.

As shown in figure 30, the curve represented by the inverted triangles represent the characteristics of ITO/PEDOT:PSS/PCPDTBT:PCBM/Alloy Based Photovoltaic Cell Having Insulating Polymeric Layer while curve represented by the circles represent the characteristics of ITO/PEDOT:PSS/PCPDTBT:PCBM/Alloy Based Photovoltaic Cell Having Insulating Polymeric Layer (without incorporation of the dye). ITO/PEDOT:PSS/PCPDTBT:PCBM/Alloy Based Photovoltaic Cell Having Dye Incorporated Insulating Polymeric Layer showed an improvement in Jsc of about 14% indicating that the red emission from the dye is indeed coupled to the active layer and the same has a positive impact.

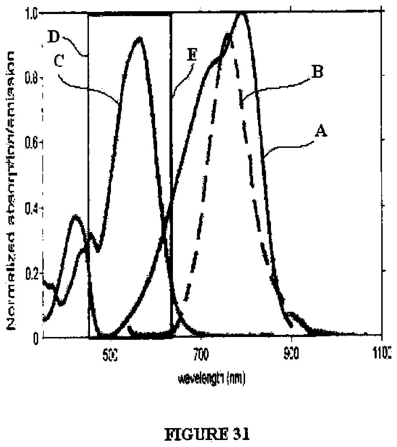

As illustrated in figure 31, the dye needs to absorb in the 500-600nm region (the region between the vertical lines D and E) and emit in the red (700-900nm) which is basically the dominant absorption band of PCPDTBT. PCPDTBT (which is the donor species and whose absorption characteristics is represented by curve A) absorbs efficiently in the red-IR region but has a very low absorption coefficient in the green. Particularly, it can be observed that the PCPDTBT donor species has very low absorption in the range of 400 to 600 nm wavelength region. Thus, if the active layer comprises PCPDTBT (as the donor species), it is preferable to incorporate in the photovoltaic solar cell a dye exhibiting high absorption in the 400-600 nm region. The dye Benzothiazolium 2-[[2- [2- [4-(dimethylamino)phenyl] ethenyl] -6-methyl-4H-pyran-4-ylidene]methyl]-3-ethyl perchlorate as shown by curve C has peak absorption in the 400 to 600 nm region and at the same time has emission characteristics as shown in curve B which is in the 700-900nm range.

### Advantages of the Invention:

Large area patterned OSCs can be fabricated in a one-step coating. The device geometry ensures that all the electrodes, whatever their shape, size and distribution, are shorted. Hence there is no requirement of an additional coating to short the electrodes as is encountered in a regular Al based patterned OSC. Any design of patterns can be easily integrated without the need of a second coating. The fabrication process only takes 10 min as compared to few hours for Al coat (including making, time taken to reach 10⁻⁶ mbar vacuum and cooling). A 60 W heating stage and solder rod are the only instruments required consuming negligible power as compared to an evaporation unit with a rotary pump, turbo pump, water pump, air compressor etc. The measurements have also shown that the polymer oxidation is a much slower process as compared to the oxidation of the cathode. The facile technique to fabricate air stable and patterned OSCs in air using low melting point alloys eliminates any need for a vacuum based coating unit. The work function of the alloy turns out to be close to that of Al and hence the efficiency of the devices was comparable to that of Al. We have fabricated large area patterned OSCs (with the area of sub-cells in the 1 mm² regime) which exhibit extended life times in excess of 500 hrs without any encapsulation. The drop in efficiency in the 400-500 hr period was only about 18 % from the time of fabrication. The open-circuit voltage (V_{oc}) was found to increase with time due to partial oxidation of Alloy at the polymer interface, which if desired, can be put to beneficial utility. Inclusion of a fluorescent dye with absorption and emission profiles customized for the donor, increased the J_{sc} and overall η by 14%. The processes involved are inherently low cost and can be applied to flexible OSCs. These materials are coated in melt phase and hence can be supported in roll-to-roll technologies.

### Acronyms used in the specification:

In the specification, the below mentioned acronyms have been used and they are intended to carry the following meaning
OSC: Organic solar cell
PBDTTT-C-T: Poly{[4,8-bis-(2-ethyl-hexyl-thiophene-5-yl)-benzo[1,2-b:4,5-b'] dithiophene-2,6-diyl]- alt -[2-(2'-ethyl-hexanoyl)-thieno[3,4-b]thiophen-4,6-diyl]}
PTB7:Poly[[4,8-bis[(2-ethylhexyl)oxy]benzo[1,2-b:4,5-b']dithiophene-2,6-diyl][3-fluoro-2-[(2-ethylhexyl)carbonyl]thieno[3,4-b]thiophenediyl]]
PCPDTBT: Poly[2,1,3-benzothiadiazole-4,7-diyl[4,4-bis(2-ethylhexyl)-4H-cyclopenta[2,1-b:3,4-b']dithiophene-2,6-diyl]
PCDTBT: Poly[[9-(1-octylnonyl)-9H-carbazole-2,7-diyl]-2,5-thiopenediyl-2, 1,3-benzothiadiazole-4,7-diyl-2,5- thiopenediyl]
P3HT: Poly(3-hexyl thiopene)
PCBM: refers to PC₆₀BM and/or PC₇₀BM
PC₆₀BM: Phenyl-C60-butyric acid methyl ester
PC₇₀BM: Phenyl-C70-butyric acid methyl ester
PEDOT:PSS: Poly(3,4-ethylwnedioxythiopene)-poly(styrene sulfonate)
PVDF: Polyvinylidene fluoride
DMA: Dimethyl acetamide
ICBA: Indene-C₆₀ Bisadduct
PS: Polystyrene
PMMA: Poly methyl methacrylate
PC: polycarbonate
PET: polyethylene terephthalate
PEO: Poly ethylene oxide
PEI: Polyethyleneimine
PEIE: Polyethyleneimine ethoxylated
PAA: poly allyl amine
**PFN:**
DCM: 4-(Dicyanomethylene)-2-methyl-6-(4-dimethylaminostyryl)-4H-pyran
ITO: Indium Tin Oxide

## Claims

1. A photo voltaic cell (100), comprising:
an anode (101) located at one extremity;
a cathode (102) located at another extremity;
a pre-patterned insulating polymeric layer (103) placed in abutting relationship with the cathode (102); and
an active layer (104) disposed between the anode (101) and the pre-patterned insulating polymeric layer (103), the said active layer generating charge carrier upon excitation by light;
the cathode (102) comprising a plurality of interconnected cathode structures (105) on a side abutting the pre-patterned insulating polymeric layer (103) and an interconnecting region (106) on an opposing side thereof, the interconnecting region further interconnecting the plurality of interconnected cathode structures.

2. A photo voltaic cell (200), comprising:
an anode (201) located at one extremity;
a cathode (202) located at another extremity;
a pre-patterned insulating polymeric layer (203) placed in abutting relationship with the anode (201); and
an active layer (204) disposed between the cathode (202) and the pre-patterned insulating polymeric layer (203), the said active layer generating charge carrier upon excitation by light;
the anode (201) comprising a plurality of interconnected anode structures (205) on a side abutting the pre-patterned insulating polymeric layer (203) and an interconnecting region (206) on an opposing side thereof, the interconnecting region further interconnecting the plurality of interconnected anode structures.

3. The photo voltaic cell (100, 200) as claimed in any of claims 1 or 2, wherein the active layer (104, 204) is an organic layer or a heterojunction layer.

4. The photo voltaic cell (100, 200) as claimed in claim 3, wherein the heterojunction layer is an organic heterojunction layer or a hybrid heterojunction layer or a bulk heterojunction system.

5. The photo voltaic cell (100, 200) as claimed in claim 4, wherein the bulk heterojunction system comprises donor species and acceptor species, wherein the donor species are selected from the group comprising of PBDTTT-C-T, PTB7, PCPDTBT, PCDTBT, P3HT and any combinations thereof, and wherein the acceptor species are selected from the group comprising of PC₆₀BM, PC₇₀BM, Indene-C60 Bisadduct (ICBA), Perylene, Perylene derivatives Naphthalene, Naphthalene derivatives, Coronene, Coronene derivatives, pyrrole, pyrrole derivatives and any combinations thereof.

6. The photo voltaic cell (100, 200) as claimed in any of claims 1 or 2, further comprising a hole-conducting layer (107, 207) disposed between the anode (101, 201) and the active layer (104, 204), wherein the hole-conducting layer (107, 207) is selected from a group comprising PEDOT: PSS, Molybdenum Oxide, Nickel oxide.

7. The photo voltaic cell (100, 200) as claimed in claim 1, wherein the cathode (102, 202) comprises Indium, Tin, Bismuth, Antimony, Cadmium, Lead and any combination thereof.

8. The photo voltaic cell (100, 200) as claimed in claim 2, wherein the anode (101, 201) comprises Indium, Tin, Bismuth, Antimony, Cadmium, Lead and any combination thereof.

9. The photo voltaic cell (100, 200) as claimed in claim 1, wherein the cathode (102, 202) is optionally in the form of a metal-polymer composite.

10. The photo voltaic cell (100, 200) as claimed in claim 2, wherein the anode (101, 201) is optionally in the form of a metal-polymer composite.

11. The photo voltaic cell (100, 200) as claimed in claim 9, wherein the metal-polymer composite cathode comprises particulate metals selected from the group comprising of Indium, Tin, Bismuth, Antimony, Cadmium, Lead and any combination thereof dispersed in a polymer matrix selected from the group comprising of polystyrene (PS), poly methyl methacrylate (PMMA) and polycarbonate (PC).

12. The photo voltaic cell (100, 200) as claimed in claim 10, wherein the metal-polymer composite anode comprises particulate metals selected from the group comprising of Indium, Tin, Bismuth, Antimony, Cadmium, Lead and any combination thereof dispersed in a polymer matrix selected from the group comprising of polystyrene (PS), poly methyl methacrylate (PMMA) and polycarbonate (PC).

13. The photo voltaic cell (100) as claimed in claim 1, further comprising a substrate (108) disposed on top of the anode (101).

14. The photo voltaic cell (200) as claimed in claim 2, further comprising a substrate (208) disposed on top of the cathode (202).

15. The photo voltaic cell (100, 200) as claimed in any of claims 13 or 14, wherein the substrate (108, 208) is made of glass or a transparent plastic material.

16. The photo voltaic (100, 200) cell as claimed in claim 15, wherein the transparent plastic material is selected from the group comprising of polyethylene terephthalate (PET), polystyrene (PS), poly methyl methacrylate (PMMA) and polycarbonate (PC).

17. The photo voltaic cell (100) as claimed in claim 1, wherein the anode (101) is selected from the group comprising of Indium Tin Oxide layer, Silver nano particle ink, gold nano particle ink, silver nanowires arranged in a grid pattern, gold nanowires arranged in a grid pattern, Gallium doped Zinc Oxide layer, highly conducting PEDOT: PSS layer and any combinations thereof.

18. The photo voltaic cell (200) as claimed in claim 2, wherein the cathode (202) is selected from the group comprising of Indium Tin Oxide layer, Silver nano particle ink, gold nano particle ink, silver nanowires arranged in a grid pattern, gold nanowires arranged in a grid pattern, Gallium doped Zinc Oxide layer, highly conducting PEDOT: PSS layer and any combinations thereof.

19. The photo voltaic cell (100) as claimed in claim 1, further comprising a hole-blocking, electron conducting layer (109) disposed between the insulating polymeric layer (103) and the active layer (104).

20. The photo voltaic cell (200) as claimed in claim 2, further comprising a hole-blocking, electron conducting layer (209) disposed between the cathode and the active layer.

21. The photo voltaic cell (100, 200) as claimed in any of claims 19 or 20, wherein the hole-blocking, electron conducting layer (109, 209) is selected from the group comprising of Zinc oxide, Titanium dioxide, Copper oxide, Calcium and Lithium Fluoride.

22. The photo voltaic cell (100) as claimed in claim 1, further comprising a buffer enhancement layer (110) disposed between the insulating polymeric layer (103) and the active layer (104).

23. The photo voltaic cell (200) as claimed in claim 2, further comprising a buffer enhancement layer (210) disposed between the cathode (202) and the active layer (204).

24. The photo voltaic cell (100, 200) as claimed in any of claims 22 or 23, wherein the buffer enhancement layer (110, 210) is made of a polyelectrolytic material selected from the group comprising of Poly ethylene oxide (PEO), Polyethyleneimine (PEI), Polyethyleneimine ethoxylated (PEIE), poly allyl amine (PAA), PFN electrolyte and any combinations thereof.

25. The photo voltaic cell (100, 200) as claimed in any one of claims 1 or 2, wherein the insulating polymeric layer (103, 203) is selected from a group comprising of Polycarbonate, PET, PMMA, PS and PVDF.

26. A method of forming a photo voltaic cell, comprising:
(a) providing an anode structure comprising an anode and an active layer disposed thereupon, the said active layer generating charge carrier upon excitation by light;
(b) forming a cathode structure by locating on a top surface of a semi-solid or molten cathode a pre-patterned insulating polymeric layer, wherein location of the pre-patterned insulating polymeric layer on the top surface of the semi-solid cathode creates the cathode comprising a plurality of interconnected cathode structures on a side abutting the pre-patterned insulating polymeric layer and an interconnecting region on an opposing side thereof, the interconnecting region further_interconnecting the plurality of interconnected cathode structures; and
(c) joining the cathode and the anode structures such that the active layer is disposed between the anode and the pre-patterned insulating polymeric layer to obtain the photo voltaic cell.

27. A method of forming a photo voltaic cell, comprising:
(a) providing a cathode structure comprising cathode and an active layer disposed thereupon, the said active layer generating charge carrier upon excitation by light;
(b) forming an anode structure by locating on a top surface of a semi-solid or molten anode a pre-patterned insulating polymeric layer, wherein location of the pre-patterned insulating polymeric layer on the top surface of the semi-solid anode creates the anode comprising a plurality of interconnected anode structures on a side abutting the pre-patterned insulating polymeric layer and an interconnecting region on an opposing side thereof, the interconnecting region further interconnecting_the plurality of interconnected anode structures; and
(c) joining the cathode and the anode structures such that the active layer is disposed between the cathode and the pre-patterned insulating polymeric layer to obtain the photo voltaic cell.

28. The method as claimed in claim 26, wherein forming the cathode structure comprises:
• placing a metal foil on a heating stage;
• inducing wetting in the metal foil;
• placing molten cathode on top of the wet foil;
• locating an insulating polymeric layer on a top surface of molten cathode to obtain the cathode structure; and
• allowing the cathode structure to cool gradually and peeling off the metal foil there-from.

29. The method as claimed in claim 27, wherein forming the anode structure comprises:
• placing a metal foil on a heating stage;
• inducing wetting in the metal foil;
• placing molten anode on top of the wet foil;
• locating an insulating polymeric layer on a top surface of molten anode to obtain the anode structure; and
• allowing the anode structure to cool gradually and peeling off the metal foil there-from.

30. The method as claimed in any of claims 28 or 29, wherein the metal foil is selected from the group comprising Aluminium, Tin and a combination thereof.

31. The method as claimed in any of claims 26 or 27, further comprising forming electrical leads from the cathode and the anode.

## Patentansprüche

1. Photovoltaische Zelle (100), die enthält:
eine Anode (101), die an einem Ende angeordnet ist;
eine Kathode (102), die an einem anderen Ende angeordnet ist;
eine vorstrukturierte isolierende Polymerschicht (103), die an der Seite der Kathode (102) angelegt ist; und
eine aktive Schicht (104), die zwischen der Anode (101) und der vorstrukturierten isolierenden Polymerschicht (103) angeordnet ist, wobei die aktive Schicht auf eine Anregung durch Licht Ladungsträger erzeugt;
die Kathode (102), die eine Vielzahl von miteinander verbundenen Kathodenstrukturen (105) an einer Seite, die an die vorstrukturierte isolierende Polymerschicht (103) angelegt ist, und einen Verknüpfungsbereich (106) an einer gegenüberliegenden Seite davon umfasst, wobei der Verknüpfungsbereich eine Vielzahl von miteinander verbundenen Kathodenstrukturen weiter miteinander verbindet.

2. Photovoltaische Zelle (200), die enthält:
eine Anode (201), die an einem Ende angeordnet ist;
eine Kathode (202), die an einem anderen Ende angeordnet ist;
eine vorstrukturierte isolierende Polymerschicht (203), die an einer Seite der Anode (201) angelegt ist; und
eine aktive Schicht (204), die zwischen der Kathode (202) und der vorstrukturierten isolierenden Polymerschicht (203) angeordnet ist, wobei die genannte aktive Schicht auf eine Anregung durch Licht Ladungsträger erzeugt;
wobei die Anode (201) eine Vielzahl von miteinander verbundenen Anodenstrukturen (205) an einer Seite, die an die vorstrukturierte isolierende Polymerschicht (203) angelegt ist, und einen Verknüpfungsbereich (206) an einer gegenüberliegenden Seite davon umfasst, wobei der Verknüpfungsbereich eine Vielzahl von miteinander verbundenen Anodenstrukturen weiter miteinander verbindet.

3. Photovoltaische Zelle (100, 200) nach einem der Ansprüche 1 oder 2, wobei die aktive Schicht (104, 204) eine organische Schicht oder eine Heteroübergangsschicht ist.

4. Photovoltaische Zelle (100, 200) nach Anspruch 3, wobei die Heteroübergangsschicht eine organische Heteroübergangsschicht oder eine Hybrid-Heteroübergangsschicht oder ein Bulk-Heteroübergangssystem ist.

5. Photovoltaische Zelle (100, 200) nach Anspruch 4, wobei das Bulk-Heteroübergangssystem Donorspezies und Akzeptorspezies enthält, wobei die Donorspezies aus der Gruppe ausgewählt werden, die aus PBDTTT-C-T, PTB7, PCPDTBT, PCDTBT, P3HT und beliebige Kombinationen davon besteht, und wobei die Akzeptorspezies aus der Gruppe ausgewählt werden, die aus PC₆₀BM, PC₇₀BM, Inden-C60-Bisaddukt (ICBA), Perylen, Perylenderivate, Naphthalin, Naphthalinderivate, Coronen, Coronenderivate, Pyrrol, Pyrrolderivate und beliebige Kombinationen davon besteht.

6. Photovoltaische Zelle (100, 200) nach einem der Ansprüche 1 oder 2, die ferner aus einer lochleitenden Schicht (107, 207), die zwischen der Anode (101, 201) und der aktiven Schicht (104, 204) angeordnet ist, besteht, wobei die lochleitende Schicht (107, 207) aus einer Gruppe ausgewählt wird, die aus PEDOT: PSS, Molybdän-Oxid, Nickel-Oxid besteht.

7. Photovoltaische Zelle (100, 200) nach Anspruch 1, wobei die Kathode (102, 202) Indium, Zinn, Bismut, Antimon, Cadmium, Blei und eine beliebige Kombination davon enthält.

8. Photovoltaische Zelle (100, 200) nach Anspruch 2, wobei die Anode (101, 201) Indium, Zinn, Bismut, Antimon, Cadmium, Blei und eine beliebige Kombination davon enthält.

9. Photovoltaische Zelle (100, 200) nach Anspruch 1, wobei die Kathode (102, 202) optional in Form eines Metall-Polymer-Verbunds ist.

10. Photovoltaische Zelle (100, 200) nach Anspruch 2, wobei die Anode (101, 201) optional in Form eines Metall-Polymer-Verbunds ist.

11. Photovoltaische Zelle (100, 200) nach Anspruch 9, wobei die Metall-Polymer-Verbund-Kathode teilchenförmige Metalle enthält, die aus der Gruppe ausgewählt werden, die Indium, Zinn, Wismut, Antimon, Cadmium, Blei und eine beliebige Kombination davon enthält, die in einer Polymermatrix dispergiert sind, die aus der Gruppe ausgewählt wird, die Polystyrol (PS), Polymethylmethacrylat (PMMA) und Polycarbonat (PC) enthält.

12. Photovoltaische Zelle (100, 200) nach Anspruch 10, wobei die Metall-Polymer-Verbund-Anode teilchenförmige Metalle enthält, die aus der Gruppe ausgewählt sind, die Indium, Zinn, Wismut, Antimon, Cadmium, Blei und eine beliebige Kombination davon enthält, die in einer Polymermatrix dispergiert sind, die aus der Gruppe ausgewählt wird, die Polystyrol (PS), Polymethylmethacrylat (PMMA) und Polycarbonat (PC) enthält.

13. Photovoltaische Zelle (100) nach Anspruch 1, die ferner ein Substrat (108) enthält, das oben auf der Anode (101) angeordnet ist.

14. Photovoltaische Zelle (200) nach Anspruch 2, die ferner ein Substrat (208) enthält, das oben auf der Kathode (202) angeordnet ist.

15. Photovoltaische Zelle (100, 200) nach einem der Ansprüche 13 oder 14, wobei das Substrat (108, 208) aus Glas oder einem transparenten Kunststoffmaterial besteht.

16. Photovoltaische Zelle (100, 200) nach Anspruch 15, wobei das transparente Kunststoffmaterial aus der Gruppe ausgewählt wird, die Polyethylenterephthalat (PET), Polystyrol (PS), Polymethylmethacrylat (PMMA) und Polycarbonat (PC) enthält.

17. Photovoltaische Zelle (100) nach Anspruch 1, wobei die Anode (101) aus der Gruppe ausgewählt wird, die eine Indium-Zinn-Oxid-Schicht, eine Silber-Nanopartikeltinte, eine Gold-Nanopartikeltinte, in einem Gittermuster angeordnete Silber-Nanodrähte, in einem Gittermuster angeordnete Gold-Nanodrähte, eine Gallium-dotierte Zink-Oxid-Schicht, eine hochleitende PEDOT: PSS-Schicht und beliebige Kombinationen davon enthält.

18. Photovoltaische Zelle (200) nach Anspruch 2, wobei die Kathode (202) aus der Gruppe ausgewählt wird, die eine Indium-Zinn-Oxid-Schicht, eine Silber-Nanopartikeltinte, eine Gold-Nanopartikeltinte, in einem Gittermuster angeordnete Silber-Nanodrähte, in einem Gittermuster angeordnete Gold-Nanodrähte, eine Gallium-dotierte Zinkoxid-Schicht, eine hochleitende PEDOT: PSS-Schicht und beliebige Kombinationen davon enthält.

19. Photovoltaische Zelle (100) nach Anspruch 1, die weiter eine lochblockierende, elektronenleitende Schicht (109), die zwischen der isolierenden Polymerschicht (103) und der aktiven Schicht (104) angeordnet ist.

20. Photovoltaische Zelle (200) nach Anspruch 2, die weiter eine lochblockierende, elektronenleitende Schicht (209) enthält, die zwischen der Kathode und der aktiven Schicht angeordnet ist.

21. Photovoltaische Zelle (100, 200) nach einem der Ansprüche 19 oder 20, wobei die lochblockierende, elektronenleitende Schicht (109, 209) aus der Gruppe ausgewählt wird, die Zinkoxid, Titandioxid, Kupferoxid, Calcium und Lithiumfluorid enthält.

22. Photovoltaische Zelle (100) nach Anspruch 1, die weiter eine Puffererweiterungsschicht (110), die zwischen der isolierenden polymeren Schicht (103) und der aktiven Schicht (104) angeordnet ist.

23. Photovoltaische Zelle (200) nach Anspruch 2, die weiter eine Puffererweiterungsschicht (210) enthält, die zwischen der Kathode (202) und der aktiven Schicht (204) angeordnet ist.

24. Photovoltaische Zelle (100, 200) nach einem der Ansprüche 22 oder 23, wobei die Puffererweiterungsschicht (110, 210) aus einem polyelektrolytischen Material besteht, das aus der Gruppe ausgewählt wird, die Polyethylenoxid (PEO), Polyethylenimin (PEI), ethoxyliertes Polyethylenimin (PEIE), Polyallylamin (PAA), PFN-Elektrolyt und beliebige Kombinationen davon enthält.

25. Photovoltaische Zelle (100, 200) nach einem der Ansprüche 1 oder 2, wobei die isolierende Polymerschicht (103, 203) aus einer Gruppe ausgewählt wird, die Polycarbonat, PET, PMMA, PS und PVDF enthält.

26. Verfahren zur Bildung einer photovoltaischen Zelle, das folgende Schritte aufweist:
(a) Bereitstellen einer Anodenstruktur, die aus einer Anode und einer darauf angeordneten aktiven Schicht besteht, wobei die genannte aktive Schicht auf eine Anregung durch Licht Ladungsträger erzeugt;
(b) Bildung einer Kathodenstruktur durch Anordnen einer vorstrukturierten isolierenden Polymerschicht auf einer oberen Oberfläche einer halbfesten oder geschmolzenen Kathode, wobei das Anordnen der vorstrukturierten isolierenden Polymerschicht auf der oberen Oberfläche der halbfesten Kathode die Kathode erzeugt, die eine Vielzahl von miteinander verbundenen Kathodenstrukturen an einer Seite, die an die vorstrukturierte isolierende Polymerschicht angelegt ist, und einen Verknüpfungsbereich an einer gegenüberliegenden Seite davon enthält, wobei der Verknüpfungsbereich weiter eine Vielzahl von miteinander verbundenen Kathodenstrukturen miteinander verbindet; und
(c) Verbinden der Kathoden- und der Anodenstrukturen, so dass die aktive Schicht zwischen der Anode und der vorstrukturierten isolierenden Polymerschicht angeordnet ist, um die photovoltaische Zelle zu erhalten.

27. Verfahren zur Bildung einer photovoltaischen Zelle, das folgende Schritte aufweist:
(a) Bereitstellen einer Kathodenstruktur, die aus einer Kathode und einer darauf angeordneten aktiven Schicht besteht, wobei die aktive Schicht bei einer Anregung durch Licht Ladungsträger erzeugt;
(b) Bildung einer Anodenstruktur durch Anordnen einer vorstrukturierten isolierenden Polymerschicht auf einer oberen Oberfläche einer halbfesten oder geschmolzenen Anode, wobei das Anordnen der vorstrukturierten isolierenden Polymerschicht auf der oberen Oberfläche der halbfesten Anode die Anode erzeugt, die eine Vielzahl von miteinander verbundenen Anodenstrukturen an einer Seite, die an die vorstrukturierte isolierende Polymerschicht angelegt ist, und einen Verknüpfungsbereich an einer gegenüberliegenden Seite davon enthält, wobei der Verknüpfungsbereich weiter eine Vielzahl von miteinander verbundenen Anodenstrukturen miteinander verbindet; und
(c) Verbinden der Kathode- und der Anodenstrukturen, so dass die aktive Schicht zwischen der Kathode und der vorstrukturierten isolierenden Polymerschicht angeordnet ist, um die photovoltaische Zelle zu erhalten.

28. Verfahren nach Anspruch 26, wobei Bildung der Kathodenstruktur folgende Schritte aufweist:
• Anordnen einer Metallfolie auf einer Heizstufe;
• Induzieren einer Benetzung in der Metallfolie;
• Anordnen einer geschmolzenen Kathode auf der nassen Folie;
• Anordnen einer isolierenden polymeren Schicht auf einer oberen Oberfläche der geschmolzenen Kathode, um die Kathodenstruktur zu erhalten; und
• allmähliches Abkühlen der Kathodenstruktur und Abziehen der Metallfolie von dort aus.

29. Verfahren nach Anspruch 27, wobei Bildung der Anodenstruktur folgende Schritte aufweist:
• Anordnen einer Metallfolie auf einer Heizstufe;
• Induzieren einer Benetzung in der Metallfolie;
• Anordnen einer geschmolzenen Anode auf der nassen Folie;
• Anordnen einer isolierenden polymeren Schicht auf einer oberen Oberfläche der geschmolzenen Anode, um die Anodenstruktur zu erhalten; und
• allmähliches Abkühlen der Anodenstruktur und Abziehen der Metallfolie von dort aus.

30. Verfahren nach einem der Ansprüche 28 oder 29, wobei die Metallfolie aus der Gruppe ausgewählt wird, die Aluminium, Zinn und eine Kombination davon enthält.

31. Verfahren nach einem der Ansprüche 26 oder 27, das weiter Bildung von elektrischen Leitungen von der Kathode und der Anode enthält.

## Revendications

1. Cellule photovoltaïque (100), comprenant :
une anode (101) située à une extrémité ;
une cathode (102) située à une autre extrémité ;
une couche polymère isolante préformée (103) placée en relation de butée avec la cathode (102) ; et
une couche active (104) disposée entre l'anode (101) et la couche polymère isolante préformée (103), ladite couche active générant un porteur de charge lors de l'excitation par la lumière ;
la cathode (102) comprenant une pluralité de structures cathodiques interconnectées (105) sur un côté en butée contre la couche polymère isolante préformée (103) et une région d'interconnexion (106) sur un côté opposé de celle-ci, la région d'interconnexion interconnectant en outre la pluralité de structures cathodiques interconnectées.

2. Cellule photovoltaïque (200), comprenant :
une anode (201) située à une extrémité ;
une cathode (202) située à une autre extrémité ;
une couche polymère isolante préformée (203) placée en relation de butée avec l'anode (201) ; et
une couche active (204) disposée entre la cathode (202) et la couche polymère isolante préformée (203), ladite couche active générant un porteur de charge lors de l'excitation par la lumière ;
l'anode (201) comprenant une pluralité de structures anodiques interconnectées (205) sur un côté en butée contre la couche polymère isolante préformée (203) et une région d'interconnexion (206) sur un côté opposé de celle-ci, la région d'interconnexion interconnectant en outre la pluralité de structures anodiques interconnectées.

3. Cellule photovoltaïque (100, 200) selon l'une quelconque des revendications 1 ou 2, dans laquelle la couche active (104, 204) est une couche organique ou une couche à hétéroj onction.

4. Cellule photovoltaïque (100, 200) selon la revendication 3, dans laquelle la couche à hétérojonction est une couche à hétérojonction organique ou une couche à hétérojonction hybride ou un système à hétérojonction en vrac.

5. Cellule photovoltaïque (100, 200) selon la revendication 4, dans laquelle le système à hétérojonction en vrac comprend des espèces donneuses et des espèces acceptrices, dans laquelle les espèces donneuses sont choisies dans le groupe comprenant PBDTTT-C-T, PTB7, PCPDTBT, PCDTBT, P3HT et toute combinaison de ceux-ci, et dans lequel les espèces acceptrices sont choisies dans le groupe comprenant le PC₆₀BM, le PC₇₀BM, le Bisadduct Indène-C60 (ICBA), le pérylène, les dérivés du pérylène, le naphtalène, les dérivés du naphtalène, le coronène, les dérivés du coronène, le pyrrole, les dérivés du pyrrole et toute combinaison de ceux-ci.

6. Cellule photovoltaïque (100, 200) selon l'une quelconque des revendications 1 ou 2, comprenant en outre une couche conductrice de trous (107, 207) disposée entre l'anode (101, 201) et la couche active (104, 204), dans laquelle la couche conductrice de trous (107, 207) est choisie dans un groupe comprenant PEDOT: PSS, l'oxyde de molybdène, l'oxyde de nickel.

7. Cellule photovoltaïque (100, 200) selon la revendication 1, dans laquelle la cathode (102, 202) comprend de l'indium, de l'étain, du bismuth, de l'antimoine, du cadmium, du plomb et toute combinaison de ceux-ci.

8. Cellule photovoltaïque (100, 200) selon la revendication 2, dans laquelle l'anode (101, 201) comprend de l'indium, de l'étain, du bismuth, de l'antimoine, du cadmium, du plomb et toute combinaison de ceux-ci.

9. Cellule photovoltaïque (100, 200) selon la revendication 1, dans laquelle la cathode (102, 202) est éventuellement sous la forme d'un composite métal-polymère.

10. Cellule photovoltaïque (100, 200) selon la revendication 2, dans laquelle l'anode (101, 201) est éventuellement sous la forme d'un composite métal-polymère.

11. Cellule photovoltaïque (100, 200) selon la revendication 9, dans laquelle la cathode composite métal-polymère comprend des métaux particulaires choisis dans le groupe comprenant de l'indium, de l'étain, du bismuth, de l'antimoine, du cadmium, du plomb et toute combinaison de ceux-ci dispersés dans une matrice polymère choisie dans le groupe comprenant le polystyrène (PS), le poly méthacrylate de méthyle (PMMA) et le polycarbonate (PC).

12. Cellule photovoltaïque (100, 200) selon la revendication 10, dans laquelle l'anode composite métal-polymère comprend des métaux particulaires choisis dans le groupe comprenant de l'indium, de l'étain, du bismuth, de l'antimoine, du cadmium, du plomb et toute combinaison de ceux-ci dispersés dans une matrice polymère choisie dans le groupe comprenant le polystyrène (PS), le poly méthacrylate de méthyle (PMMA) et le polycarbonate (PC).

13. Cellule photovoltaïque (100) selon la revendication 1, comprenant en outre un substrat (108) disposé sur le dessus de l'anode (101).

14. Cellule photovoltaïque (200) selon la revendication 2, comprenant en outre un substrat (208) disposé sur le dessus de la cathode (202).

15. Cellule photovoltaïque (100, 200) selon l'une quelconque des revendications 13 ou 14, dans laquelle le substrat (108, 208) est constitué de verre ou d'une matière plastique transparente.

16. Cellule photovoltaïque (100, 200) selon la revendication 15, dans laquelle la matière plastique transparente est choisie dans le groupe comprenant le polyéthylène téréphtalate (PET), le polystyrène (PS), le poly méthacrylate de méthyle (PMMA) et le polycarbonate (PC).

17. Cellule photovoltaïque (100) selon la revendication 1, dans laquelle l'anode (101) est choisie dans le groupe comprenant une couche d'oxyde d'indium-étain, une encre à base de nanoparticules d'argent, une encre à base de nanoparticules d'or, des nanofils d'argent disposés selon un motif en grille, des nanofils d'or disposés selon un motif en grille, une couche d'oxyde de zinc dopée au gallium, une couche de PEDOT: PSS hautement conductrice et toute combinaison de ceux-ci.

18. Cellule photovoltaïque (200) selon la revendication 2, dans laquelle la cathode (202) est choisie dans le groupe comprenant une couche d'oxyde d'indium-étain, une encre à base de nanoparticules d'argent, une encre à base de nanoparticules d'or, des nanofils d'argent disposés selon un motif en grille, des nanofils d'or disposés selon un motif en grille, une couche d'oxyde de zinc dopée au gallium, une couche de PEDOT: PSS hautement conductrice et toute combinaison de ceux-ci.

19. Cellule photovoltaïque (100) selon la revendication 1, comprenant en outre une couche de blocage de trous conduisant les électrons (109) disposée entre la couche polymère isolante (103) et la couche active (104).

20. Cellule photovoltaïque (200) selon la revendication 2, comprenant en outre une couche de blocage de trous conduisant les électrons (209) disposée entre la cathode et la couche active.

21. Cellule photovoltaïque (100, 200) selon l'une quelconque des revendications 19 ou 20, dans laquelle la couche de blocage de trous conduisant les électrons (109, 209) est choisie dans le groupe comprenant l'oxyde de zinc, le dioxyde de titane, l'oxyde de cuivre, le calcium et le fluorure de lithium.

22. Cellule photovoltaïque (100) selon la revendication 1, comprenant en outre une couche tampon d'amélioration (110) disposée entre la couche polymère isolante (103) et la couche active (104).

23. Cellule photovoltaïque (200) selon la revendication 2, comprenant en outre une couche tampon d'amélioration (210) disposée entre la cathode (202) et la couche active (204).

24. Cellule photovoltaïque (100, 200) selon l'une quelconque des revendications 22 ou 23, dans laquelle la couche tampon d'amélioration (110, 210) est constituée d'un matériau polyélectrolytique choisi dans le groupe comprenant le polyéthylène oxyde (PEO), la polyéthylèneimine (PEI), la polyéthylèneimine éthoxylée (PEIE), la polyallylamine (PAA), l'électrolyte PFN et toute combinaison de ceux-ci.

25. Cellule photovoltaïque (100, 200) selon l'une quelconque des revendications 1 ou 2, dans laquelle la couche polymère isolante (103, 203) est choisie dans un groupe comprenant le polycarbonate, le PET, le PMMA, le PS et le PVDF.

26. Procédé de formation d'une cellule photovoltaïque, comprenant les étapes suivantes :
(a) la fourniture d'une structure d'anode comprenant une anode et une couche active disposée sur celle-ci, ladite couche active générant un porteur de charge lors de l'excitation par la lumière ;
(b) la formation d'une structure de cathode en plaçant une couche polymère isolante préformée sur une surface supérieure d'une cathode semi-solide ou fondue, dans laquelle la mise en place de la couche polymère isolante préformée sur la surface supérieure de la cathode semi-solide crée la cathode comprenant une pluralité de structures de cathode interconnectées sur un côté en butée contre la couche polymère isolante préformée et une région d'interconnexion sur un côté opposé de celle-ci, la région d'interconnexion interconnectant en outre la pluralité de structures de cathode interconnectées ; et
(c) l'assemblage des structures de cathode et d'anode de sorte que la couche active soit disposée entre l'anode et la couche polymère isolante préformée pour obtenir la cellule photovoltaïque.

27. Procédé de formation d'une cellule photovoltaïque, comprenant les étapes suivantes :
(a) la fourniture d'une structure de cathode comprenant une cathode et une couche active disposée sur celle-ci, ladite couche active générant un porteur de charge lors de l'excitation par la lumière ;
(b) la formation d'une structure d'anode en plaçant une couche polymère isolante préformée sur une surface supérieure d'une anode semi-solide ou fondue, dans laquelle l'emplacement de la couche polymère isolante préformée sur la surface supérieure de l'anode semi-solide crée l'anode comprenant une pluralité de structures d'anode interconnectées sur un côté en butée contre la couche polymère isolante préformée et une région d'interconnexion sur un côté opposé de celle-ci, la région d'interconnexion interconnectant en outre la pluralité de structures d'anode interconnectées ; et
(c) l'assemblage des structures de cathode et d'anode de sorte que la couche active soit disposée entre la cathode et la couche polymère isolante préformée pour obtenir la cellule photovoltaïque.

28. Procédé selon la revendication 26, dans lequel la formation de la structure de cathode comprend :
• le placement d'une feuille métallique sur un étage de chauffage ;
• l'induction du mouillage dans la feuille métallique ;
• le placement de la cathode fondue sur le dessus de la feuille humide ;
• la mise en place d'une couche polymère isolante sur une surface supérieure de la cathode fondue pour obtenir la structure de cathode ; et
• le refroidissement progressif de la structure de cathode et le décollement de la feuille métallique de celle-ci.

29. Procédé selon la revendication 27, dans lequel la formation de la structure d'anode comprend les étapes suivantes :
• le placement d'une feuille métallique sur un étage de chauffage ;
• l'induction du mouillage dans la feuille métallique ;
• le placement de l'anode fondue sur le dessus de la feuille humide ;
• la mise en place d'une couche polymère isolante sur une surface supérieure de l'anode fondue pour obtenir la structure d'anode ; et
• le refroidissement progressif de la structure d'anode et le décollement de la feuille métallique de celle-ci.

30. Procédé selon l'une quelconque des revendications 28 ou 29, dans lequel la feuille métallique est choisie dans le groupe comprenant de l'aluminium, de l'étain et une combinaison de ceux-ci.

31. Procédé selon l'une quelconque des revendications 26 ou 27, comprenant en outre la formation de conducteurs électriques à partir de la cathode et de l'anode.
